# EUROPEAN PATENT APPLICATION

(11) **EP 1 715 357 A1**
(43) Date of publication of application: **25.10.2006**
(21) Application number: 05709924.4
(22) Date of filing: 02.02.2005
(51) Int. Cl.: G01R 33/465, G01N 24/08

(54) **NMR SIGNAL ASSIGNMENT METHOD**

(30) Priority: 02.02.2004 JP 2004025592
(71) Applicant: MITSUBISHI CHEMICAL CORPORATION, Tokyo 108-0014 (JP)
(72) Inventor: KOHNO, Toshiyuki, Machida-shi, Tokyo 194-8511 (JP)
(74) Representative: HOFFMANN EITLE
(86) International application number: PCT/JP2005/001872
(87) International publication number: WO 2005/073747

(57) **Abstract**

It is an object of the present invention to provide a method of efficiently and rapidly determining the assignment of signals obtained by the ¹H-¹⁵N HSQC measurement or the like, and a method of efficiently and rapidly identifying the three-dimensional structure of a target protein using the above method or a method of identifying the binding site of a protein of interest to a ligand, in place of the conventional signal assignment method, which requires a protein with a concentration several to 10 times higher than the lowest concentration of a protein capable of being observed by a high sensitive ¹H-¹⁵N HSQC measurement method. In the present invention, ¹⁵N/¹³C double-labeled amino acids, ¹⁵N-labeled amino acids, and non-labeled amino acids are systematically combined and used as substrates with respect to every amino acids constituting a protein of interest, so as to synthesize multiple proteins (20 types or 39 types of proteins at the maximum), and the NMR measurement is performed on such multiple proteins by a measurement method capable of identifying the correlation signals of two amino acid residues adjacent to each other, and then the obtained signals are compared.

## Description

### TECHNICAL FIELD

The present invention relates to a method of carrying out NMR measurement using a protein formed by the combination of ¹⁵N/¹³C-labeled amino acids with ¹⁵N-labeled amino acids or the like, so as to rapidly and reliably determine the assignment of the signals of atoms that constitute the main chain of the protein in terms of amino acid residue numbers, such as a correlation signal of an amide proton with ¹⁵N (which may be referred to as "¹H-¹⁵N HSQC spectrum" or "¹H-¹⁵N correlation signal" in the present specification), using a protein with a low concentration. The present invention also relates to a method of determining the assignment of the signals of all atoms including the side chain of the protein based on such amino acid residue numbers.

### BACKGROUND ART

Nitrogen atoms contained in a protein are labeled with ¹⁵N, which is a stable isotope and can be observed by NMR, and ¹H-¹⁵N HSQC (heteronuclear single quantum coherence) spectrum can be then observed, so as to determine the assignment of each signal obtained by the NMR measurement such as a ¹H-¹⁵N HSQC spectrum, including the type and number of the amino acid of each signal (refer to Cavanagh, W. J. et al., Protein NMR Spectroscopy, Principles and Practice, Academic Press (1996), for example). Based on such data, the three-dimensional structure of a protein can be determined (refer to Montelione, G. T., et al., Nature Struct. Biol., 7, Suppl, 982-985 (2000), for example), or screening of a ligand binding to the protein or identification of a binding site can be carried out (refer to Zerbe O. et al., BioNMR in Drug Research, Wiley (2003), for example).

The measurement method using a ¹H-¹⁵N HSQC spectrum is one of methods involving the highest sensitivity among protein NMR measurement methods. However, when the assignment of each signal from ¹H-¹⁵N HSQC spectrum, including the type and number of the amino acid of each signal, is determined, it has been necessary that a target protein sample with a high concentration (approximately 250 µl at 1 mM) be prepared by a certain means, that a plurality of three-dimensional NMR measurements be carried out at a room temperature or higher over several weeks, and that a complicated analysis be then carried out (refer to Montelione, G. T., et al., Nature Struct. Biol., 7, Suppl, 982-985 (2000), for example). In particular, when the assignment of the ¹H-¹⁵N HSQC spectrum of a protein with a molecular weight of larger than 10,000 is determined by the conventional method, in order to prevent the overlapping of signals, it has been necessary that multiple types of three-dimensional NMR measurement methods be applied to improve the separation of signals. In addition, in order to prevent the unclearness of assignment, a measurement method involving low sensitivity (refer to Sattler, M., et al., Prog. NMR Spectroscopy, 34 (1999) 93-158, for example) has been used in combination. As a result, it has been necessary to prepare a ¹³C/¹⁵N double-labeled protein having a concentration 10 to 20 times higher than that of a protein sample necessary for the ¹H-¹⁵N HSQC measurement method which is a multinuclear two-dimensional NMR method with the highest sensitivity. Thus, a protein with low solubility could not be analyzed.

In general, it is often difficult to dissolve a high molecular weight protein in a solution with a high concentration such as approximately 1 mM. In addition, it is also often difficult to allow such a protein to be stably present at a room temperature or higher for several weeks. Moreover, even if such two conditions are satisfied and various types of spectra can be measured, several or more weeks are required for an expert to conduct the subsequent analysis.

Furthermore, as a method of determining the assignment of a signal without using the three-dimensional NMR method, a method of identifying the ¹H-¹⁵N HSQC signal of a single residue, using a target protein wherein only C of one type of amino acid has been labeled with ¹³C and only another type of amino acid has been labeled with ¹⁵N, has been reported (refer to Yabuki, T. et al., J. Biomol. NMR, 11, 295-306 (1998), for example). The problems regarding the concentration of a protein of interest and the stability of a protein have been solved by this method. However, in order to practically apply this method to determination of the assignment of all the signals of ¹H-¹⁵N HSQC, several tens to several hundreds types of proteins of interest, which have been labeled in various ways, should be prepared, and a complicated template should also be produced using suppressor tRNA. Accordingly, this method has never been applied to determination of the assignment of all the signals of a protein obtained by NMR such as ¹H-¹⁵N HSQC. In addition, as described above, WO2002/33406 also describes a method of labeling an amino acid of interest with ¹³C and labeling an amino acid adjacent thereto with ¹⁵N, so as to detect a ¹H-¹⁵N correlation signal adjacent to ¹³C. However, this method has also required the synthesis of proteins wherein all types of combinations of amino acids adjacent to one another have been labeled. Moreover, this method has been problematic in that the assignment of signals cannot be determined when amino acids adjacent to each other are present at two or more sites in the same alignment.

Thus, a method of simply determining the assignment of signals obtained by NMR such as a ¹H-¹⁵N HSQC spectrum, in terms of the type and number of amino acids, using a small amount of protein of interest with a low concentration, has been desired.

### DISCLOSURE OF THE INVENTION

It is an object of the present invention to provide a method of efficiently and rapidly determining the assignment of signals obtained by the ¹H-¹⁵N HSQC measurement or the like, and a method of efficiently and rapidly identifying the three-dimensional structure of a target protein using the above method or a method of identifying the binding site of a protein of interest to a ligand, in place of the conventional signal assignment method, which requires a protein with a concentration several to 10 times higher than the lowest concentration of a protein capable of being observed by a high sensitive ¹H-¹⁵N HSQC measurement method. It is another object of the present invention to provide a reagent kit used for the aforementioned method of the present invention of determining the assignment of signals obtained by the NMR measurement of a protein.

As a result of intensive studies directed towards achieving the aforementioned objects, the present inventors have systematically combined ¹⁵N/¹³C double-labeled amino acids, ¹⁵N-labeled amino acids, and non-labeled amino acids, and have used them as substrates with respect to every amino acids constituting a protein of interest, so as to synthesize multiple proteins (20 types or 39 types of proteins at the maximum). Thereafter, the present inventors have performed the NMR measurement on such multiple proteins by a measurement method capable of identifying the correlation signals of two amino acid residues adjacent to each other, and have compared the obtained signals. As a result, the present inventors have found that the assignment of the signals obtained by the NMR measurement can be determined by the above method. The present invention has been completed based on these findings.

That is to say, the present invention provides the following features:
(1) A method of determining the assignment of a signal obtained by the NMR measurement of a protein, which comprises:
   (i) preparing a protein, wherein the carbon atom(s) at position 2 and/or at position 1 and the nitrogen atom at position 2 of either one of amino acids adjacent to an amino acid to be identified on the amino acid sequence of the protein have been double-labeled for the NMR measurement, and wherein any one of nitrogen, carbon, and hydrogen atoms at position 2 of at least the amino acid to be identified has been labeled for the NMR measurement;
   (ii) performing on the above-described protein, the NMR measurement, which is capable of identifying only the correlation signal of the amide proton of an amino acid residue to be identified, adjacent to the double-labeled amino acid, with the labeled atom; and
   (iii) comparing the above-described signal with the correlation signal of the amide proton of an amino acid residue to be identified with the labeled atom, which is obtained by the NMR measurement of a protein wherein any one of nitrogen, carbon, and hydrogen atoms at position 2 of the amino acid to be identified has been labeled, so as to determine the assignment of the signal of the amino acid to be identified.
(2) A method of determining the assignment of a signal obtained by the NMR measurement of a protein, which comprises:
   (i) preparing a protein, wherein the carbon atoms at positions 2 and 1 have been labeled with ¹³C and the nitrogen atom at position 2 has been labeled with ¹⁵N, with respect to either one of amino acids adjacent to an amino acid to be identified on the amino acid sequence of the protein, and wherein the nitrogen atom at position 2 of at least the amino acid to be identified has been labeled with ¹⁵N;
   (ii) performing on the above-described protein, the NMR measurement, which is capable of identifying only the correlation signal of the amide proton of an amino acid residue to be identified, adjacent to the double-labeled amino acid, with ¹⁵N; and
   (iii) comparing the above-described signal with the correlation signal of the amide proton of an amino acid residue to be identified with ¹⁵N, which is obtained by the NMR measurement of a protein wherein only the nitrogen atom at position 2 of an amino acid to be identified has been labeled with ¹⁵N, so as to determine the assignment of the signal of the amino acid to be identified.
(3) A method of determining the assignment of a signal obtained by the NMR measurement of a protein, which comprises:
   (a) determining the assignment with respect to either one of amino acids adjacent to an amino acid to be identified on the amino acid sequence of a protein according to the method described in (2) above;
   (b) preparing a protein, wherein the carbon atoms at positions 2 and 1 of the above-described amino acid have been labeled with ¹³C and the nitrogen atom at position 2 thereof has been labeled with ¹⁵N, and the nitrogen atom at position 2 of at least the amino acid to be identified has been labeled with ¹⁵N;
   (c) performing on the above-described protein, the NMR measurement, which is capable of identifying only the correlation signal of the ¹³C of the double-labeled amino acid residue with the amide proton, and the correlation signal of the ¹³C of the double-labeled amino acid residue with the amide proton of the adjacent amino acid residue to be identified;
   (d) obtaining the correlation signal of the amide protons of the amino acid to be identified and the above double-labeled amino acid with ¹⁵N;
   (e) selecting from the signals obtained in (c) above, a signal having a chemical shift identical to the chemical shift of the amide protons of amino acids, whose assignment has been determined, in the signal obtained in (d) above;
   (f) selecting from the signals obtained in (c) above, a signal having a chemical shift identical to the chemical shift of the ¹³C of the selected signal; and
   (g) selecting from the signals obtained in (c) above, a signal having a chemical shift identical to the chemical shift of the amide proton of the selected signal, and then determining the assignment of the above-described signal, using the fact that the above signal is assigned to an amino acid adjacent to the amino acid whose assignment has been determined.
(4) The method according to (3) above, wherein, in step (c), the NMR measurement is further carried out to identify only the correlation signal of the ¹³C of the double-labeled amino acid residue with the amide proton of the adjacent amino acid residue to be identified, and it is confirmed that the signal selected in step (f) overlaps the signal as obtained above.
(5) A method of determining the assignment of a signal obtained by the NMR measurement of a protein, which comprises:
   (i) preparing a protein, wherein the carbon atom at positions 1 of either one of amino acids adjacent to an amino acid to be identified on the amino acid sequence of the protein has been labeled with ¹³C and the nitrogen atoms at position 2 of multiple amino acids including the amino acid to be identified have been labeled with ¹⁵N;
   (ii) performing on the above-described protein, the NMR measurement, which is capable of identifying only the correlation signal of the amide proton of the amino acid residue to be identified, adjacent to the ¹³C-labeled amino acid, with ¹⁵N; and
   (iii) comparing the above-described signal with the correlation signal of the amide proton of the amino acid residue to be identified with ¹⁵N, which is obtained by the NMR measurement of a protein wherein the nitrogen atom at position 2 of only the amino acid to be identified has been labeled with ¹⁵N, so as to determine the assignment of the signal of the amino acid to be identified.
(6) A method of determining the assignment of all signals obtained by the NMR measurement of a protein, which comprises repeating the method according to (1) or (5) above, or combining the method according to (3) above with the method according to (4) above.
(7) A method of determining the assignment of the correlation signal of the amide proton with ¹³C or the amide proton with ²H, obtained by the NMR measurement of a protein, which comprises:
   (i) determining the assignment of the correlation signal of the amide proton of a protein with ¹⁵N by the methods according to (2) to (6) above;
   (ii) preparing a protein, wherein the carbon atom(s) or hydrogen atom(s) at position 2 and/or at position 1 of an amino acid to be identified on the amino acid sequence of the above-described protein have been double-labeled for the NMR measurement;
   (iii) obtaining the correlation signal of the amide proton in the amino acid to be identified with the carbon atom(s) or hydrogen atom(s) of the same amino acid, which have been labeled for the NMR measurement, with respect to the above-described protein; and
   (iv) using, as an indicator, the fact that amide protons common in the correlation signal of the amide proton with ¹⁵N in (i) above and in the correlation signal of the amide proton with ¹³C or with ²H in (iii) above have the same chemical shift, and associating the correlation signal of the amide proton with ¹³C or with ²H, with the correlation signal of the above-described amide proton with ¹⁵N, so as to determine the assignment of the correlation signal of the amide proton with ¹³C or with ²H.
(8) A method of identifying the three-dimensional structure of a protein, wherein the chemical shift information of the NMR signal whose assignment has been determined by the method according to (6) or (7) above is used.
(9) A method of identifying the binding site of a protein to a ligand, which comprises:
   comparing signals obtained by the NMR measurement of a complex of a protein and a specific ligand, with signals obtained by the NMR measurement of only a protein; and
   determining by the method according to any one of (1) to (7) above, the assignment of a signal whose chemical shift has been changed.
(10) A reagent kit used for the method of determining the assignment of signals obtained by the NMR measurement of a protein by the method according to any one of (1) to (7) above, which comprises: one or more types of amino acids, wherein at least the carbon atoms at positions 2 and 1 have been labeled with ¹³C and the nitrogen atom at position 2 has been labeled with ¹⁵N; and multiple amino acids wherein the nitrogen atom at position 2 has been labeled with ¹⁵N and the carbon atoms at positions 2 and 1 have not been labeled with ¹³C.
(11) A reagent kit used for the method of determining the assignment of signals obtained by the NMR measurement of a protein by the method according to any one of (1) to (7) above, which comprises: one or more types of amino acids, wherein at least the carbon atoms at positions 2 and 1 have been labeled with ¹³C and the nitrogen atom at position 2 has been labeled with ¹⁵N; multiple amino acids wherein the nitrogen atom at position 2 has been labeled with ¹⁵N and the carbon atoms at positions 2 and 1 have not been labeled with ¹³C; a wheat germ extract for a cell-free protein synthesis; and an amino acid metabolic enzyme inhibitor.

### BRIEF DESCRIPTION OF THE DRAWINGS

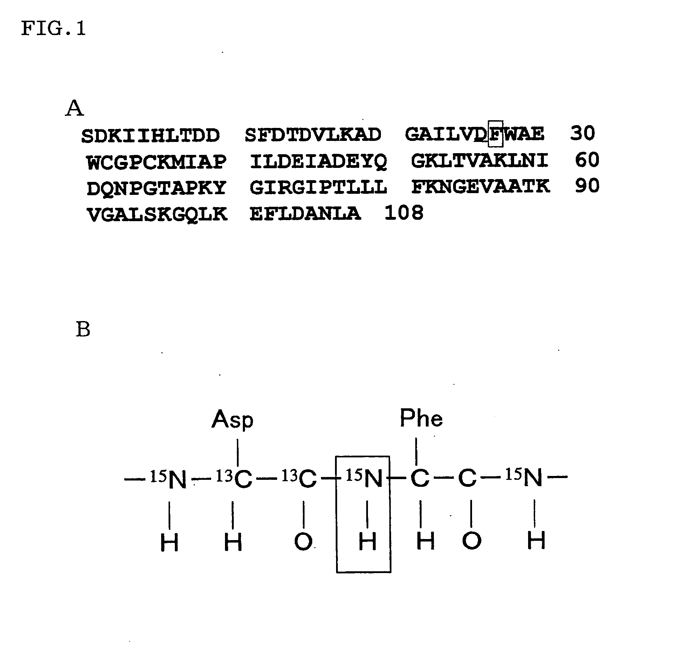

Figure 1 is a view showing the amino acid sequence of an *Escherichia coli* thioredoxin protein and the ¹H-¹⁵N HSQC spectrum thereof.

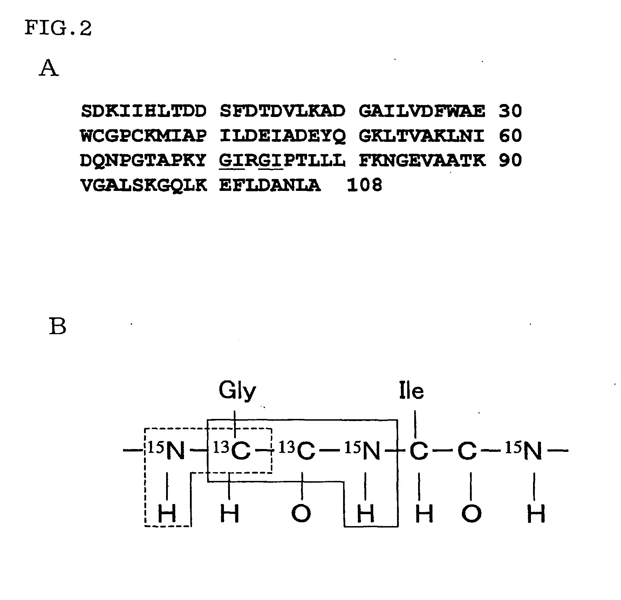

Figure 2 is a view showing the amino acid sequence of an *Escherichia coli* thioredoxin protein, the H(N)CA measurement thereof, and the H(NCO)CA measurement thereof.

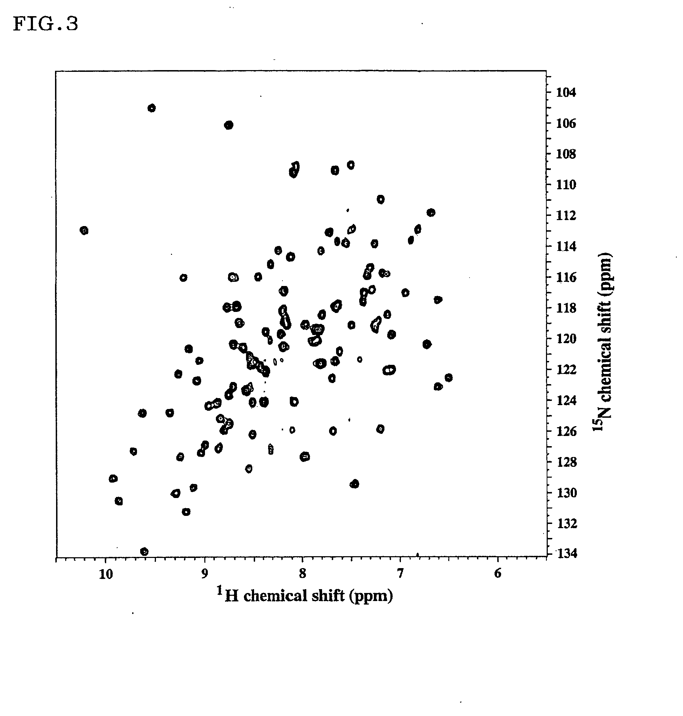

Figure 3 is a view showing the results obtained by measuring the ¹H-¹⁵N HSQC spectrum of an *Escherichia coli* thioredoxin protein, wherein all amide nitrogens in the main chain have been labeled with ¹⁵N.

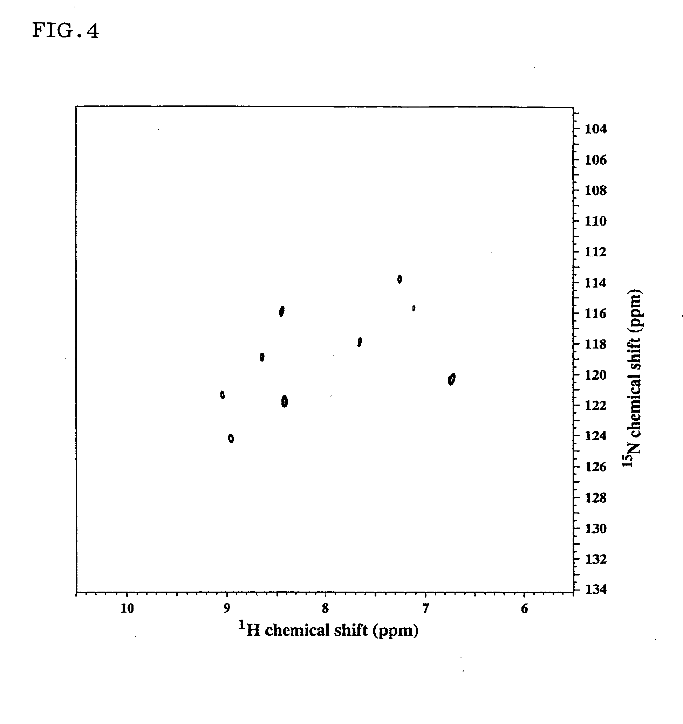

Figure 4 is a view showing the results obtained by measuring the HN(CO) spectrum of an *Escherichia coli* thioredoxin protein, wherein only alanine has been double-labeled with ¹³C/¹⁵N and all other amino acids have been labeled with ¹⁵N.

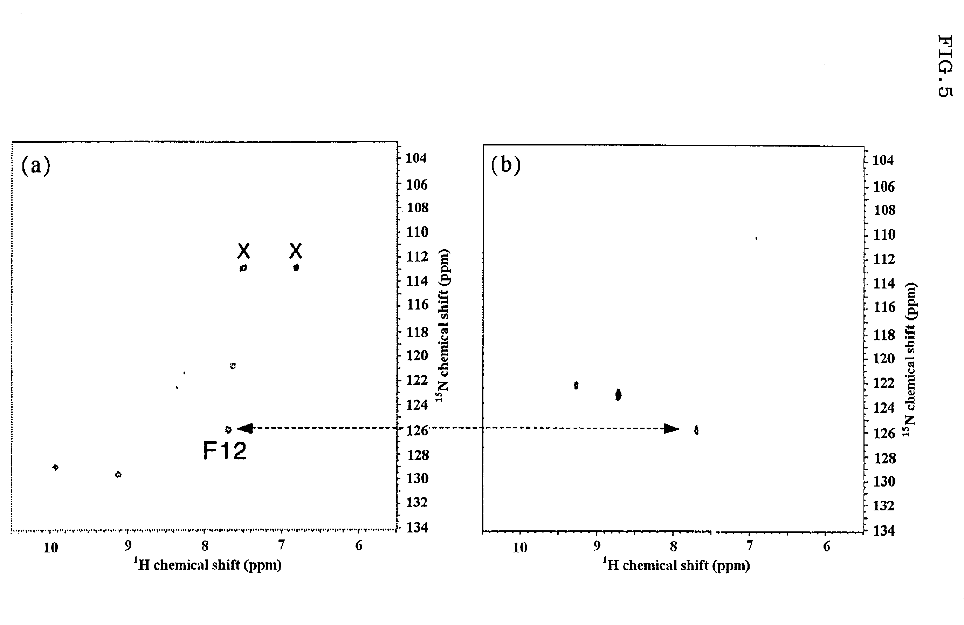

Figure 5 is a view showing the results obtained by measuring the ¹H-¹⁵N HSQC spectrum (a) of an *Escherichia coli* thioredoxin protein, wherein only phenylalanine has been labeled with ¹⁵N, and the HN(CO) spectrum (b) of an *Escherichia coli* thioredoxin protein, wherein only serine has been double-labeled with ¹³C/¹⁵N and all other amino acids have been labeled with ¹⁵N.

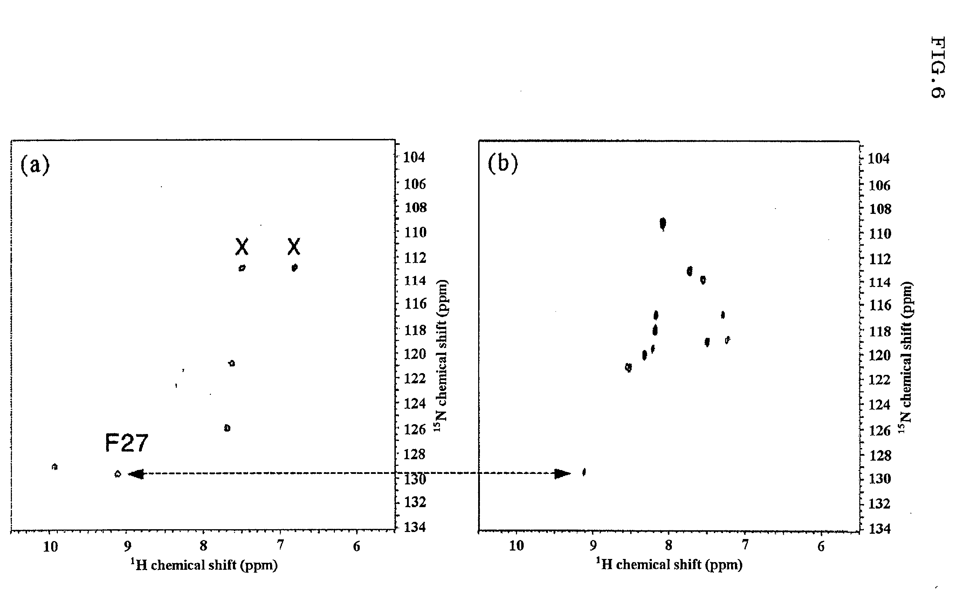

Figure 6 is a view showing the results obtained by measuring the ¹H-¹⁵N HSQC spectrum (a) of an *Escherichia coli* thioredoxin protein, wherein only phenylalanine has been labeled with ¹⁵N, and the HN(CO) spectrum (b) of an *Escherichia coli* thioredoxin protein, wherein only aspartic acid has been double-labeled with ¹³C/¹⁵N and all other amino acids have been labeled with ¹⁵N.

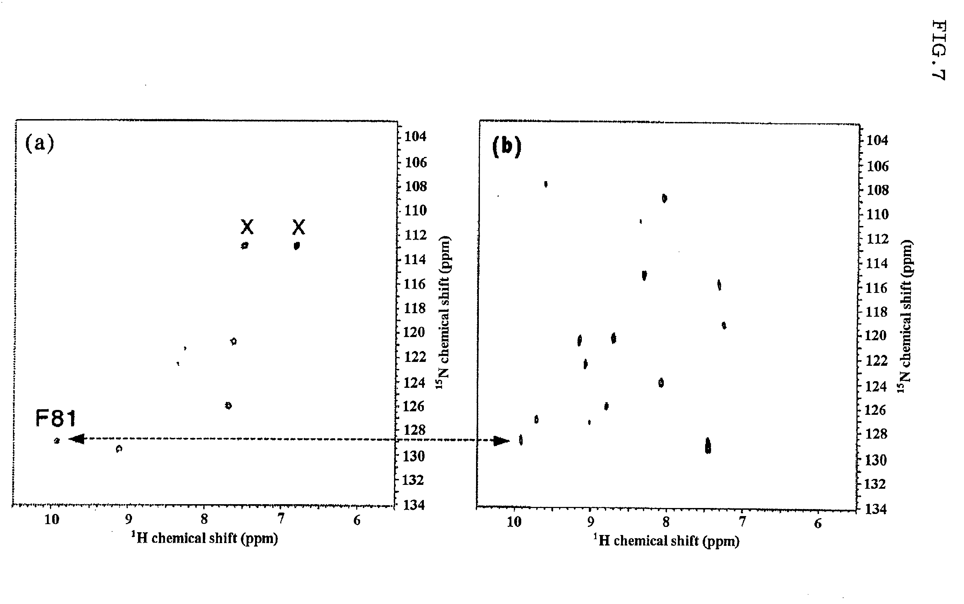

Figure 7 is a view showing the results obtained by measuring the ¹H-¹⁵N HSQC spectrum (a) of an *Escherichia coli* thioredoxin protein, wherein only phenylalanine has been labeled with ¹⁵N, and the HN(CO) spectrum (b) of an *Escherichia coli* thioredoxin protein, wherein only leucine has been double-labeled with ¹³C/¹⁵N and all other amino acids have been labeled with ¹⁵N.

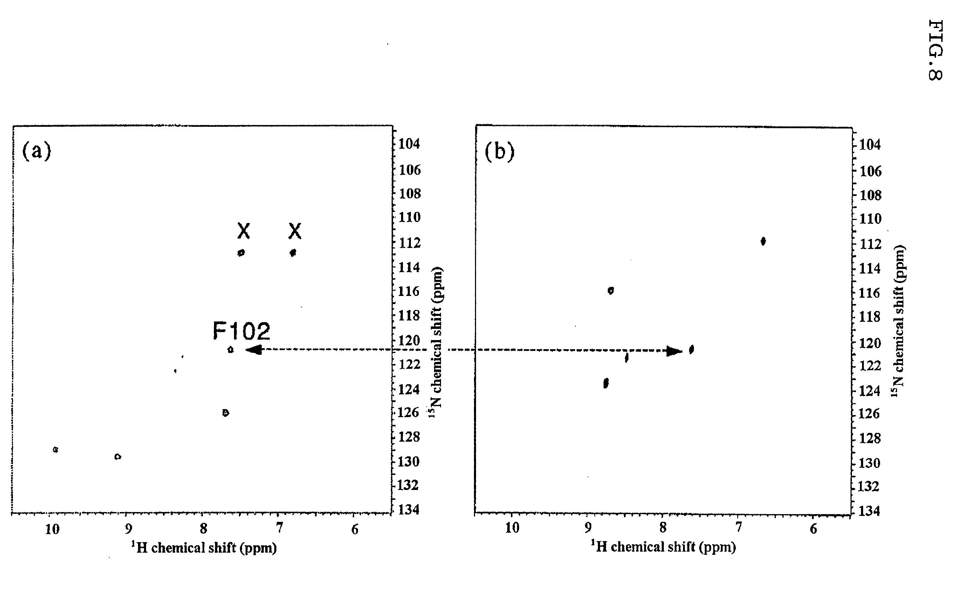

Figure 8 is a view showing the results obtained by measuring the ¹H-¹⁵N HSQC spectrum (a) of an *Escherichia coli* thioredoxin protein, wherein only phenylalanine has been labeled with ¹⁵N, and the HN(CO) spectrum (b) of an *Escherichia coli* thioredoxin protein, wherein only glutamic acid has been double-labeled with ¹³C/¹⁵N and all other amino acids have been labeled with ¹⁵N.

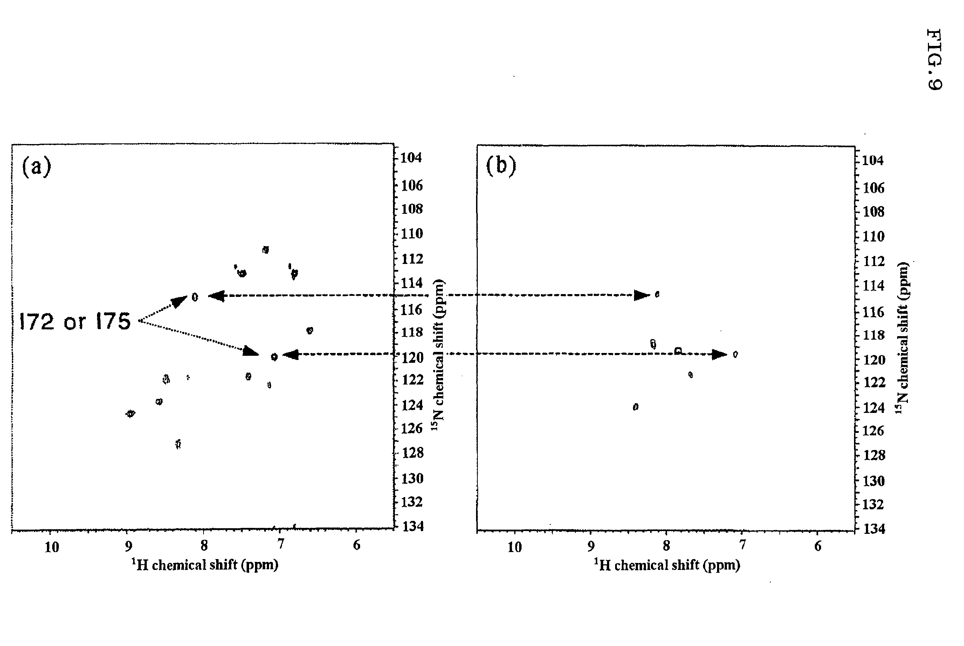

Figure 9 is a view showing the results obtained by measuring the ¹H-¹⁵N HSQC spectrum (a) of an *Escherichia coli* thioredoxin protein, wherein only isoleucine has been labeled with ¹⁵N, and the HN(CO) spectrum (b) of an *Escherichia coli* thioredoxin protein, wherein only glycine has been double-labeled with ¹³C/¹⁵N and all other amino acids have been labeled with ¹⁵N.

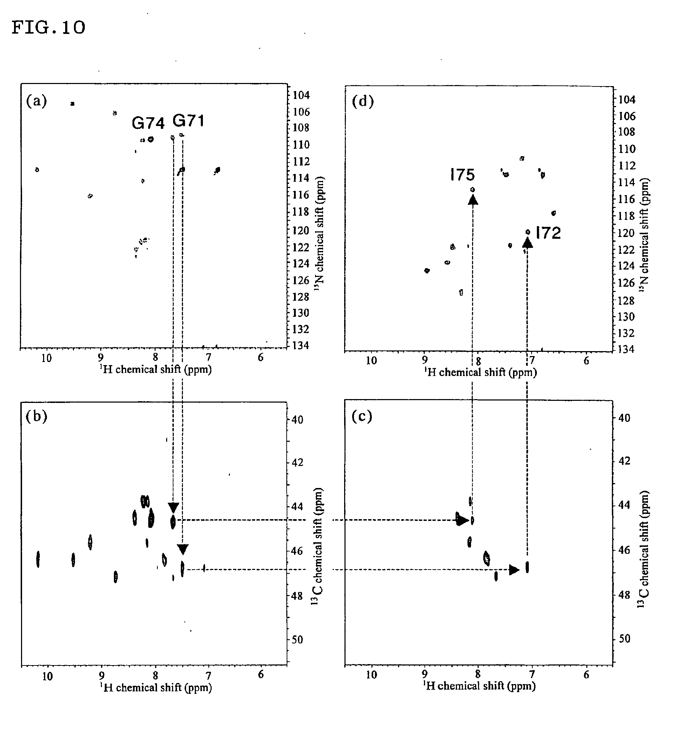

Figure 10 is a view showing a method of determining the assignment of isoleucines at positions 72 and 75, which have not been determined in Figure 9.

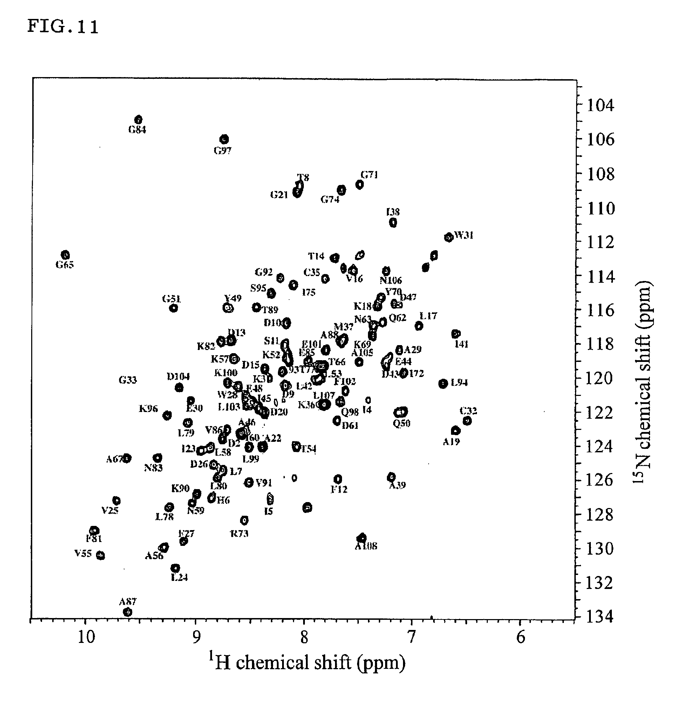

Figure 11 is a view showing the results obtained by determining the assignment of almost all signals of the ¹H-¹⁵N HSQC spectrum of an *Escherichia coli* thioredoxin protein, wherein all amide nitrogens in the main chain have been labeled with ¹⁵N.

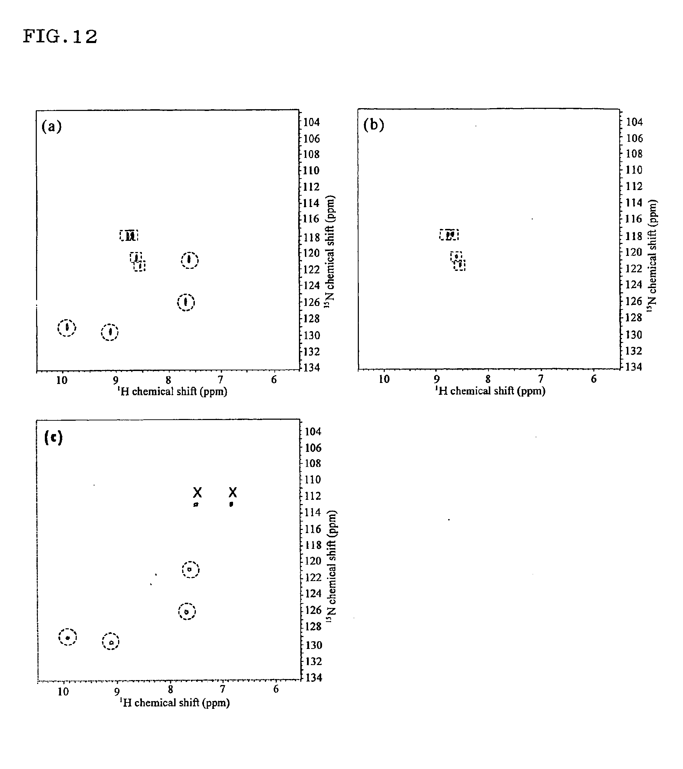

Figure 12 is a view showing: the HN(CA) spectrum (a) and HN(CO) spectrum (b) of an *Escherichia coli* thioredoxin protein, wherein only phenylalanine has been double-labeled with ¹³C/¹⁵N and all other amino acids have been labeled with ¹⁵N; and the ¹H-¹⁵N HSQC spectrum (c) of an *Escherichia coli* thioredoxin protein, wherein only phenylalanine has been labeled with ¹⁵N.

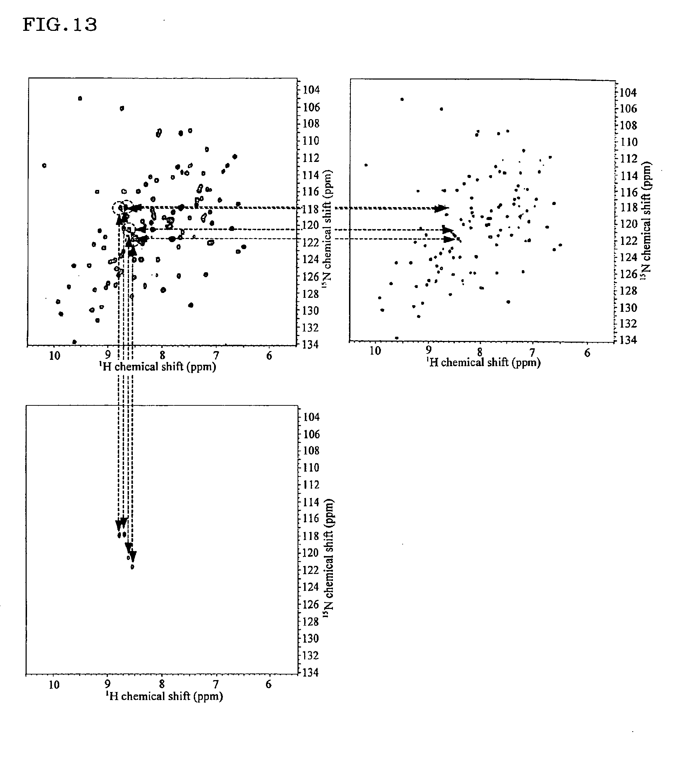

Figure 13 is a view showing: the ¹H-¹⁵N HSQC spectrum (a) of an *Escherichia coli* thioredoxin protein, wherein all amide nitrogens in the main chain have been labeled with ¹⁵N; and spectrum (b) obtained by measuring all ¹H-¹⁵N correlations that are not adjacent to a ¹³C carbonyl group and the HN(CO) spectrum (c), which are obtained with respect to an *Escherichia coli* thioredoxin protein, wherein only phenylalanine has been double-labeled with ¹³C/¹⁵N and all other amino acids have been labeled with ¹⁵N.

### BEST MODE FOR CARRYING OUT THE INVENTION

The present invention will be more specifically described below.

### (1-1) Method of determining the assignment of signals obtained by NMR measurement (Method 1)

The assignment method of the present invention is a method, which comprises: synthesizing a protein of interest by systematically combining ¹³C/¹⁵N double-labeled amino acids, amino acids labeled with any one of ¹⁵N, ¹³C, and ²H, and non-labeled amino acids, for every amino acids constituting the protein; performing on the synthesized protein, the NMR measurement, which is capable of obtaining the correlation signals of two amino acid residues adjacent to each other; and comparing the obtained signals with the signals obtained from a protein wherein each amino acid has been labeled, so as to determine the assignment thereof. The summary of such an assignment method will be described below, giving the case of the ¹H-¹⁵N correlation signal of a protein of interest as an example. The details of constitutional components used, a production method thereof, and NMR measurement method, are as described in (2) to (5) below.

The type of a protein of interest, the assignment of the signal of which is to be determined, is not limited, as long as the amino acid sequence thereof has been identified. Specifically, those described in (2) below can be used. First, with regard to amino acid, the assignment of the correlation signal of which is to be determined (27F in Figure 1A, for example), either one of amino acids adjacent to the amino acid on the amino acid sequence is specified (26D in the case of 27F in Figure 1A, for example). Thereafter, with regard to such amino acid (aspartic acid, for example), an amino acid wherein the carbon atoms at position 2 (position α) and at position 1 (position carbonyl) have been labeled with ¹³C and the nitrogen atom at position 2 has been labeled with ¹⁵N (hereinafter referred to as "¹³C/¹⁵N double-labeled amino acid" at times), and other amino acids wherein only the nitrogen atom at position 2 has been labeled with ¹⁵N, are used as substrates, so as to synthesize a protein of interest. When the correlation signal of 27F of a protein having the amino acid sequence shown in Figure 1A is to be identified, the synthesized protein is a protein, wherein aspartic acid (D) has been double-labeled with ¹³C/¹⁵N, and only nitrogen atoms have been labeled with ¹⁵N with respect to other amino acids.

Subsequently, the obtained protein is subjected to the NMR analysis, which is capable of obtaining only the correlation signal of the amide proton of an amino acid residue adjacent to the ¹³C/¹⁵N double-labeled amino acid with ¹⁵N. Specifically, such NMR analysis is an analytic method of identifying only the correlation signals among atoms in a portion enclosed with the square shown in Figure 1B, for example. An example of such NMR measurement method is HN(CO) measurement. Hereinafter, such a method of measuring only the correlation signal of the amide proton of an amino acid adjacent to the double-labeled amino acid with ¹⁵N may be referred to as "HN(CO) measurement" at times. For example, the results obtained by the NMR measurement of the protein having the amino acid sequence shown in Figure 1A, which has been labeled as described above, are shown in Figure 6(b). The signal obtained as a result of the HN(CO) measurement is of an amino acid residue adjacent to the C-terminal side of the double-labeled amino acid. For example, the signals shown in Figure 6(b) are of amino acids adjacent to the C-terminal side of the double-labeled amino acid D, namely, 3K, 10D, 115, 14T, 16V, 21G, 27F, 44E, 48E, 61Q, and 105A of the amino acid sequence shown in Figure 1A.

Herein, the HN(CO) measurement capable of obtaining only the ¹H-¹⁵N correlation signal of an amino acid adjacent to the C-terminal side of the double-labeled amino acid is conducted. However, if there is a measurement method capable of obtaining only the ¹H-¹⁵N correlation signals of amino acids adjacent to the N-terminal side of the double-labeled amino acid, such a measurement method may also be applied.

A method of selecting the signal of the amino acid of interest (27F) from among these signals comprises: synthesizing a protein of interest, using, as a substrate, an amino acid wherein only the nitrogen atom at position 2 of the amino acid of interest has been labeled with ¹⁵N; obtaining the ¹H-¹⁵N correlation signal of the synthesized protein by the NMR measurement; and comparing the above ¹H-¹⁵N correlation signal with the ¹H-¹⁵N correlation signal obtained by the above HN(CO) measurement. Specifically, with regard to a protein having the amino acid sequence shown in Figure 1A for example, a protein of interest is synthesized using, as a substrate, an amino acid, wherein only the nitrogen atom at position 2 of phenylalanine (F) has been labeled with ¹⁵N, and the ¹H-¹⁵N correlation signal of the above protein is obtained by the NMR measurement. In this case, the obtained signal is the ¹H-¹⁵N correlation signal of an amino acid corresponding to phenylalanine including 27F. An example of such a signal is that shown in Figure 6(a). The signal (Figure 6(a)) is compared with the signal obtained by the HN(CO) measurement (Figure 6(b)), and it can be identified that the overlapping signal (the signal expressed with the circle in Figure 6(b)) is of the amino acid to be identified (27F).

The ¹H-¹⁵N correlation signal of the amino acid to be identified, which is used to compare with the aforementioned ¹H-¹⁵N correlation signal obtained by the HN(CO) measurement, may be obtained by the following method. First, a ¹³C/¹⁵N double-labeled amino acid is used as an amino acid to be identified, and ¹⁵N-labeled amino acids are used as other amino acids. Using these amino acids as substrates, a protein of interest is synthesized. Thereafter, the synthesized protein is subjected to the NMR measurement (hereinafter referred to as "HN(CA) measurement" at times), which detects both the correlation signal of the amide proton in the double-labeled amino acid with ¹⁵N and the correlation signal of the amide proton in an amino acid adjacent thereto with ¹⁵N. At the same time, the same protein is subjected to the HN(CO) measurement to obtain a signal, and the obtained signal is compared with the signals obtained by the HN(CA) measurement. Herein, a signal that does not overlap is the signal of the same amino acid including the amino acid of interest.

The number of "amino acid to be identified" may be either one or plural. The case of identifying the ¹H-¹⁵N correlation signals of three amino acids using two types of double-labeled amino acids will be described below. For example, with regard to a protein having the amino acid sequence shown in Figure 1A, when a protein of interest, wherein only a histidine residue (6H) and tryptophan residues (W28 and W31) have been double-labeled with ¹³C/¹⁵N, and the other amino acid residues have been labeled with only ¹⁵N, is used, the application of the aforementioned method enables unique determination of amino acid residues (L7, A29, and C32) located immediately after the above three amino acid residues. In this case, assignment procedures become somewhat complicated, but the number of samples can be reduced to less than 20 types.

In addition, when it is not necessary to determine the assignment of all the ¹H-¹⁵N correlation signals, in other words, when it is sufficient to determine the assignment of an amino acid residue, regarding which the combination of an amino acid to be identified with an amino acid adjacent thereto is singly present in the sequence of a protein of interest, the amino acid adjacent to the amino acid to be identified is not necessarily double-labeled with ¹³C/¹⁵N. That is to say, it is sufficient that the carbon atom at position 1 thereof be labeled with ¹³C. In this case, a protein, wherein the nitrogen atoms at position 2 of multiple amino acids including the amino acid to be identified have been labeled with ¹⁵N, is synthesized as a protein of interest. Thereafter, the synthesized protein is subjected to the HN(CO) measurement or the like to obtain signals, and the combination of these signals are then compared with the ¹H-¹⁵N correlation signal of a protein, wherein only the amino acid to be identified has been labeled with ¹⁵N, so as to determine the assignment of the signals, as described above. When compared with the conventional method which comprises synthesizing a protein wherein the carbon atom at position 1 has been labeled with ¹³C and the nitrogen atom at position 2 of the amino acid to be identified has been labeled with ¹⁵N, and obtaining signals by the HN(CO) measurement, this method has such effect that a few types of labeled proteins are used.

The aforementioned method is repeated, so as to determine the assignment of signals obtained by NMR, in terms of all the amino acids of a protein of interest. The aforementioned method can be used only in a case where the combination of an amino acid to be identified with an amino acid adjacent thereto (D and F in Figure 1A) is singly present in the sequence of a protein of interest.

### (1-2) Method of determining the assignment of signals obtained by NMR measurement (Method 2)

When two or more combinations of an amino acid to be identified with an amino acid adjacent thereto are present in a protein of interest (for example, 71G/72I, 74G/75I, or the like in a protein having the amino acid sequence shown in Figure 2A), first, (i) with regard to either one of amino acids adjacent to the amino acid to be identified on the amino acid sequence of the protein of interest, the assignment of the correlation signal of a specific atom with amide proton is determined by the aforementioned method. Subsequently, with regard to (ii) the correlation signal of a specific atom in the amino acid residue whose assignment has been determined with amide proton and (iii) the correlation signal of the same specific atom as that in (i) in the amino acid to be identified with amide proton, (iv) the correlation signals of atoms existing between them with each amide proton are obtained, and they are associated with one another based on the fact that the common atoms have the same chemical shifts, so as to identify that it is the correlation signal of an amino acid adjacent to the amino acid whose assignment has been determined, thereby determining the assignment thereof.

For example, when such a specific atom is the carbon atom at position 2, with respect to the correlation signal of the carbon atom at position 2 in the previously obtained amino acid residue whose assignment has been determined with amide proton, the correlation signal of the carbon atom at position 2 in the amino acid residue, whose assignment has been determined, with amide proton in an amino acid residue to be identified (adjacent thereto) is selected, based on the fact that the carbon atoms at position 2 of the amino acid residues whose assignment has been determined that are common in such two types of signals have the same chemical shift. Moreover, with respect to the correlation signal of the carbon atom at position 2 in the selected amino acid residue whose assignment has been determined with amide proton in the amino acid residue to be identified (adjacent thereto), the correlation signal of the carbon atom at position 2 in the amino acid residue to be identified with amide proton in the above amino acid residue is selected, based on the fact that the amide protons in the amino acid residues to be identified that are common in such two types of signals have the same chemical shift, so as to determine the assignment of the signal of the amino acid to be identified. Such a correlation signal can be obtained by the aforementioned H(N)CA method, for example.

Furthermore, when such a specific atom is the nitrogen atom at position 2, the assignment of the correlation signal of amide proton with the nitrogen atom can be determined by the following method.

First, (a) the assignment of either one of amino acids adjacent to an amino acid to be identified on the amino acid sequence of a protein of interest is determined by the method described in (1) above. When the signals of 72I and 75I are to be identified in a protein having the amino acid sequence shown in Figure 2A for example (hereinafter, this case may be referred to as "in the case of the exemplified protein" at times), the assignment of the ¹H-¹⁵N correlation signal is determined, with regard to each of 71G adjacent to 72I to be identified and 74G adjacent to 75I to be identified, based on the relationship with amino acids adjacent (70Y and 73R in the case of the exemplified protein), according to the method described in (1) above.

Subsequently, (b) a protein, wherein the carbon atoms at positions 2 and 1 of an amino acid adjacent to the amino acid to be identified have been labeled with ¹³C, the nitrogen atom at position 2 has been labeled with ¹⁵N, and further at least the nitrogen atom at position 2 of the amino acid to be identified has been labeled with ¹⁵N, is synthesized. In the case of the exemplified protein, a protein, wherein the carbon atoms at positions 2 and 1 of glycine adjacent to 721 and 751 have been labeled with ¹³C, the nitrogen atom at position 2 has been labeled with ¹⁵N, and at least the nitrogen atom at position 2 of isoleucine to be identified has been labeled with ¹⁵N, is synthesized.

Thereafter, (c) the obtained protein is subjected to the NMR measurement such as the H(N)CA method, which is capable of obtaining the correlation signal of the ¹³C of the double-labeled amino acid residue (glycine in the case of the exemplified protein) with amide proton (the dotted line portion in Figure 2B) and the correlation signal of the ¹³C of the double-labeled amino acid residue (glycine in the case of the exemplified protein) with the amide proton of an amino acid residue to be identified adjacent thereto (isoleucine in the case of the exemplified protein) (the solid line portion in Figure 2B) (hereinafter referred to as "H(N)CA measurement" at times), thereby obtaining signals. In the case of the exemplified protein, the obtained signals are shown in Figure 10(b). Thereafter, (d) the correlation signal of the amide protons of an amino acid residue to be identified (isoleucine in the case of the exemplified protein) and the aforementioned double-labeled amino acid residue (glycine in the case of the exemplified protein) is obtained by the H(NCO)CA method or the like (hereinafter referred to as "H(NCO)CA method" at times). In the case of the exemplified protein, examples of the signals obtained by the present measurement method are shown in Figure 10(c).

Subsequently, a signal, which has a chemical shift identical to the chemical shift of the amide proton of an amino acid whose assignment has been determined (71 G or 74G in the case of the exemplified protein) in the signals obtained in (d) above, is selected from among the signals obtained in (c) above. In the case of the exemplified protein, a chemical shift identical to the chemical shift of the amide proton of the signal of 71G or 74G shown in Figure 10(a) is selected from the signals shown in Figure 10(b) (in Figure 10(b), it is expressed with the arrow).

Thereafter, (f) a signal having a chemical shift identical to the chemical shift of the ¹³C of the selected signal is selected from among the signals obtained in (c) above, and (g) a signal having a chemical shift identical to the chemical shift of the amide proton of the selected signals is then selected from among the signals obtained in (d) above. Herein, the selected signals are determined to be the signals of amino acids adjacent to the amino acid that is assigned to the original signal. In the case of the exemplified protein, a signal having a chemical shift identical to the chemical shift of the ¹³C of the signal expressed with the arrow shown in Figure 10(b) is selected from among the signals shown in Figure 10(c) (signals expressed with the arrow in Figure 10(c)). Further, a signal having a chemical shift identical to the chemical shift of the amide proton of the selected signal is selected from among the signals obtained in Figure 10(d) (signals expressed with the arrow in Figure 10(d)). These signals can be assigned to the signal of 72I adjacent to 71G and that of 75I adjacent to 74G.

### (1-3) Method of determining the assignment of signals obtained by NMR measurement (Method 3)

First, the assignment of the ¹H-¹⁵N correlation signal of a protein of interest is determined by the methods described in (1-1) and (1-2) above. Thereafter, based on such assignment, the correlation signal of the amide proton of the amino acid of the protein of interest with ¹³C (hereinafter referred to as "¹H-¹³C correlation signal" at times) or the correlation signal of amide proton with ²H, can be determined. Specifically, (i) the assignment of the correlation signal of the amide proton of the protein with ¹⁵N is determined by the aforementioned method, and (ii) a protein, wherein the carbon atom(s) or hydrogen atom(s) at position 2 and/or 1 of an amino acid to be identified have been double-labeled on the amino acid sequence thereof such that the protein can be measured by NMR, is prepared. Thereafter, (iii) with regard to the prepared protein, the correlation signal of the amide proton in the amino acid to be identified with the carbon atom(s) or hydrogen atom(s) of the same amino acid labeled such that it can be measured by NMR is obtained. Thereafter, (iv) using, as an indicator, the fact that the amide protons, which are common to the correlation signal of the amide proton with ¹⁵N described in (i) above and the correlation signal of the amide proton with ¹³C or with ²H described in (iii) above, have the same chemical shift, the correlation signal of the amide proton with ¹³C or with ²H are allowed to correlate with the correlation signal of the amide proton with ¹⁵N, so as to determine the assignment of the correlation signal of the amide proton with ¹³C or with ²H.

Either a single type of amino acid or multiple types of amino acids may be identified herein. In addition, all amino acids may also be identified. The number of such amino acids to be identified is not particularly limited, as long as the correspondence of signals can be carried out without overlapping in the correspondence of signals described below. The method of synthesizing a protein of interest wherein an amino acid to be identified has been double-labeled, and the method of obtaining the correlation signal of the amide proton in the amino acid to be identified in the above protein with the carbon atom or hydrogen atom of the same amino acid labeled such that it can be measured by NMR, are as described in (1-1) and (1-2) above. Specifically, a method of performing the measurement of H(N)CO or H(NCO)CA on the aforementioned double-labeled protein of interest is applied. For example, in the case of H(N)CO, the correlation signal of the amide proton in amino acid located after the double-labeled amino acid with the carbon (¹³C) at position 1 of the double-labeled amino acid can be obtained. In the case of H(NCO)CA, the correlation signal of the amide proton in an amino acid located after the double-labeled amino acid with the carbon (¹³C) at position 2 of the double-labeled amino acid can be obtained.

Subsequently, the chemical shift of the amide proton of the obtained correlation signal is focused. Signals having the same chemical shift are selected from among amide protons of the ¹H-¹⁵N correlation signal whose assignment has been determined, and their assignment is referred, so as to easily determine the assignment of signals obtained by the measurement of H(N)CO and H(NCO)CA. Not only the measurement of H(N)CO and H(NCO)CA, but also the measurement of H(NCA)CO, H(N)CA, etc., enables determination of the assignment of signals by the completely same method.

The aforementioned method is a method of determining the assignment using the chemical shift of the carbon atom at position 1 or 2, after determining the assignment of the ¹H-¹⁵N correlation signal. However, the assignment method is not limited thereto. For example, the combination of the H(N)CA spectrum with the H(NCO)CA spectrum of the protein of interest that has been labeled in the same above manner, or the combination of the H(N)CO spectrum with the H(NCA)CO spectrum, is successively obtained. Thereafter, the correlation of the chemical shift of the carbon atom at position 1 or 2 in the amino acids located before and after it with the chemical shift of the amide proton is allowed to successively correlate with one another by the same above method, so as to determine the assignment of the correlation signal of amide proton with ¹³C.

Representative labeling methods, measurement methods, and assignment methods have been described above. However, the method of the present invention is not limited to the aforementioned methods.

With regard to a labeling method for example, in the aforementioned labeling methods, only the amino acid C (any given amino acid) has been double-labeled with ¹³C/¹⁵N, and other amino acids have been labeled with ¹⁵N, so as to prepare a protein of interest. However, amino acids to which measurement signals are actually given are only the amino acid C and an amino acid residue located immediately after it. Accordingly, even if only the type of the amino acid located after the amino acid residue C has been labeled with ¹⁵N in the amino acid sequence of a protein of interest, the same HN(CO), HN(CA), and HN(CO)CA spectra as those in the case where all the remaining amino acids have been labeled with ¹⁵N can be obtained. In addition, it is not necessary that only a single type of amino acid be double-labeled with ¹³C/¹⁵N with regard to a single protein sample, but the assignment of signals can also be determined, as appropriate, by double-labeling several types of amino acids with ¹³C/¹⁵N and labeling other amino acids with ¹⁵N. In this case, the number of necessary labeled proteins can be reduced to less than 20 types. However, since the analysis becomes somewhat complicated, a labeling method may be changed as necessary.

### (2) Protein of interest

The protein of interest used in the present invention may be produced by any methods such as chemical synthesis, synthesis using a recombinant, or cell-free protein synthesis, as long as amino acids can be selectively labeled by the method described below. Specific examples of such a protein may include a polypeptide, a glycoprotein or a derivative thereof, a covalent body, and a complex. A polypeptide consisting of 10 to 1,000 amino acid residues is preferably used. A glycoprotein having a molecular weight between 1,000 and 100,000 is preferable. Specifically, the protein of interest used in the present invention includes a naturally occurring protein, a portion thereof, an artificially produced polypeptide, a protein produced by adding one or more amino acid residues to the N- or C-terminus of such a naturally occurring protein, and the like. However, examples of such a protein are not limited thereto. These proteins or polypeptides may also comprise a deletion, substitution, or addition of one or several amino acid residues.

### (3) Labeled amino acid

The method of the present invention comprises: systematically synthesizing several proteins of interest, using, as substrates, an amino acid wherein the carbon atoms at positions 2 and 1 have been labeled with ¹³C and the nitrogen atom at position 2 has been labeled with ¹⁵N (hereinafter referred to as a "¹³C/¹⁵N double-labeled amino acid" at time), an amino acid wherein any one of the nitrogen atom, carbon atom, and hydrogen atom at position 2 has been labeled such that it can be measured by NMR, and a non-labeled amino acid; and then conducting the NMR measurement, so as to determine the assignment of the obtained signals as described in (1) above. Any type of ¹³C/¹⁵N double-labeled amino acid can be used, as long as the carbon atoms at positions 2 and/or 1 are ¹³C, the nitrogen atom at position 2 is ¹⁵N, and the amide group in the main chain is ¹H. Other portions may be or may not be labeled with ¹³C and ¹⁵N. Examples of an amino acid to be identified may include: an amino acid, wherein the nitrogen atom at position 2 has been labeled with ¹⁵N, the carbon atoms at positions 1 and 2 have not been labeled with ¹³C, and amide proton is ¹H (hereinafter referred to as a "¹⁵N labeled amino acid" at times); an amino acid, wherein the carbon atoms at positions 1 and/or 2 have been labeled with ¹³C, and the nitrogen atom at position 2 and amide proton have not been labeled (hereinafter referred to as a "¹³C labeled amino acid" at times); and an amino acid, wherein amide proton and/or the hydrogen atom at position 2 are deuterium, and the nitrogen atom at position 2 and the carbon atoms at positions 1 and 2 have not been labeled (hereinafter referred to as a "deuterium labeled amino acid" at times). Other portions may be or may not be labeled.

Moreover, with regard to hydrogen atoms in the aforementioned ¹³C/¹⁵N double-labeled amino acid, ¹⁵N labeled amino acid, and ¹³C labeled amino acid, it is necessary that only the amide group in the main chain be ¹H, and other portions may be substituted with an isotope such as D. In particular, in the case of a protein with a high molecular weight, if hydrogen atoms other than the amide group are deuterated, signal intensity obtained by the aforementioned NMR is significantly enhanced. Thus, it is preferable that deuterated amino acids be used as a portion or all of hydrogen atoms other than the amide group.

Any type of non-labeled amino acid may be used, as long as both the carbon atoms at positions 1 and 2 have not been labeled with ¹³C, and the nitrogen atom at position 2 has not been labeled with ¹⁵N.

Since amide proton does not originally exist in proline, the ¹H-¹⁵N HSQC spectrum described later is not given. Accordingly, either using the ¹³C/¹⁵N double-labeled amino acid or using the ¹³C labeled amino acid, the same results are obtained. Even using the ¹⁵N labeled amino acid, or using non-labeled proline, the same results are obtained. Thus, any one of these amino acids may be used.

As a method of producing the ¹³C/¹⁵N double-labeled amino acid, ¹⁵N labeled amino acid, ¹³C labeled amino acid, and deuterium labeled amino acid, a commonly used method can be applied. In addition, commercially available labeled amino acids (a labeled amino acid manufactured by Cambridge Isotope Laboratories, for example) can also be used.

### (4-1) Method of synthesizing labeled protein

A method of synthesizing multiple proteins of interest using, as substrates, the labeled or non-labeled amino acids described in (2) above, which have been systematically combined with one another, will be described below, giving labeled amino acid is used for determination of the assignment of the ¹H-¹⁵N correlation signal.

The combination of labeled amino acids with non-labeled amino acids is as described in detail in (1) above.

When the signals of 20 types of amino acids obtained by the NMR measurement are to be identified, the following proteins of interest are prepared. Examples of such a protein of interest may include: 19 types of proteins (excluding proline), wherein only one type of amino acid is a ¹⁵N labeled amino acid and the other amino acids are non-labeled amino acids; and 20 types of proteins, wherein only one type of amino acid is a ¹³C/¹⁵N double-labeled amino acid and the other amino acids are ¹⁵N labeled amino acids. Of these, 19 types of proteins (excluding proline), wherein only one type of amino acid is a ¹⁵N labeled amino acid and other amino acids are non-labeled amino acids, may be excluded.

Any type of method of synthesizing a protein using, as substrates, labeled and non-labeled amino acids, may be used, as long as a protein of interest can be synthesized in an NMR measurable form. Specifically, a cell-free protein synthetic system is preferably used, and a cell-free protein synthetic system using a wheat germ extract is particularly preferably used. Examples of such a wheat germ extract may include: those prepared in accordance with Sawasaki, et al., Proc. Natl. Acad. Sci. USA., 97, 559-564 (2000), Japanese Patent Application Laid-Open No.2000-2368996, Japanese Patent Application Laid-Open No. 2002-125693, Japanese Patent Application Laid-Open No. 2002-204689, etc.; and commercially available products such as PROTEIOS™ (manufactured by TOYOBO).

As a template for such a protein of interest, it is preferable that DNA encoding the amino acid sequence of the protein of interest is ligated under the control of a suitable expression control region, and the resultant be transcribed into RNA. In addition, a template wherein a sequence for termination of the transcription, a non-translated region, and the like, are ligated to the downstream thereof, is preferably used. The expression control region includes a promoter, an enhancer, and the like. Specifically, the expression control region described in Sawasaki, et al., Proc. Natl. Acad. Sci. USA., 97, 559-564 (2000), or the like, can be used.

After a template for a protein of interest has been transcribed into RNA, the resultant is purified by ethanol precipitation or the like. Thereafter, the aforementioned cell extract such as a wheat germ, a substrate, an energy source, various types of ions, and the like, are added to the resultant, and the obtained mixture is then reacted for a suitable period of time, so as to synthesize a protein.

When a wheat germ extract is used for the synthesis of a protein of interest, alanine is metabolized into aspartic acid and glutamic acid, aspartic acid is metabolized into glutamic acid, and glutamic acid is metabolized into aspartic acid or glutamine, by the action of amino acid metabolic enzyme contained in the above extract. Accordingly, when labeled amino acids are used as the aforementioned amino acids, it is necessary to synthesize a protein of interest under conditions wherein the activity of the above amino acid metabolic enzyme is inhibited and the translation of template RNA into a protein is not inhibited.

Such conditions wherein the activity of the above amino acid metabolic enzyme is inhibited and the translation of template RNA into a protein is not inhibited can be selected based on the following consideration. First, a concentration, in which a substance selected as a candidate for the above amino acid metabolic enzyme inhibitor does not inhibit the ability of the above protein synthetic system to synthesize a protein, is determined. For example, template RNA for a certain protein is translated using a non-labeled substrate, and the protein obtained after the translation is separated by SDS-polyacrylamide gel electrophoresis or the like, and is then quantified. Otherwise, it may also be possible that an enzyme protein whose activity measurement method has been known, or a protein having fluorescence, be translated, and that the obtained protein be quantified using the enzyme activity or fluorescent amount of the above protein as an indicator. By such quantification, a concentration range in which an amino acid metabolic enzyme inhibitor existing in the above protein synthetic system does not reduce the amount of a protein to be synthesized, is determined. Furthermore, a substance that inhibits the metabolism of an amino acid of interest is added within a concentration range wherein translation of the determined template RNA into a protein is not inhibited. For example, template RNA of a protein whose amino acid sequence has been determined is translated using a substrate, wherein only an amino acid of interest has been preferably labeled with a stable isotope, in the above cell-free protein synthetic system. A protein obtained after the translation is subjected to the NMR measurement described later to confirm whether the labeling by the added substrate is not observed in other amino acids, so as to select it. When the degree of inhibiting the metabolism of an amino acid of interest is changed depending on the concentration of a candidate substance existing in the above synthetic reaction, the concentration necessary for sufficiently inhibiting the metabolism of the amino acid is measured. Such a selection method can be substituted with the use of the previously known amino acid metabolic enzyme inhibitor.

Specific examples of the amino acid metabolic enzyme inhibitor used in the present invention may include a transaminase inhibitor and a glutamine synthetase inhibitor.

When a protein is synthesized using labeled alanine as a substrate, and when labeled aspartic acid is used as a substrate, as specific conditions, the conditions wherein a transaminase inhibitor is allowed to exist in a translation reaction solution used in the cell-free protein synthetic method described below, within a concentration range where it does not inhibit the protein-synthesizing activity, are selected. Herein, transaminase remains in the aforementioned wheat germ extract and has the activity of metabolizing alanine into aspartic acid and glutamic acid and/or the activity of metabolizing aspartic acid into glutamic acid. As such a transaminase activity inhibitor, an inhibitor having an overlapped concentration range that inhibits transaminase activity and that does not inhibit the synthesis of a protein of interest in the above synthetic system is preferably used. A specific example is aminooxyacetic acid. The concentration of aminooxyacetic acid is preferably between 0.01 and 10 mM.

In addition, examples of the conditions applied when labeled glutamic acid is used as a substrate may include conditions wherein a transaminase inhibitor and a glutamine synthetase inhibitor are allowed to exist in the translation reaction solution used in the cell-free protein synthetic method described below, within a concentration range where it does not inhibit the protein-synthesizing activity. Herein, transaminase remains in the aforementioned wheat germ extract and has the activity of metabolizing glutamic acid into aspartic acid. Glutamine synthetase remains in the aforementioned wheat germ extract and has the activity of metabolizing glutamic acid into glutamine. As such a transaminase activity inhibitor, an inhibitor having an overlapped concentration range that inhibits transaminase activity and that does not inhibit the synthesis of a protein of interest in the above synthetic system is preferably used. A specific example of the transaminase inhibitor is aminooxyacetic acid. The concentration of aminooxyacetic acid is preferably between 0.01 and 10 mM. An example of the glutamine synthetase inhibitor is L-methionine sulfoximine. The concentration of L-methionine sulfoximine is preferably between 0.01 and 20 mM.

The type of a cell-free protein synthetic method, which is applied under such conditions, is not particularly limited, as long as it is a method comprising: adding template RNA, a substrate, an energy source, or the like, to the aforementioned wheat germ extract; and further adding the aforementioned substance necessary for inhibiting amino acid metabolic activity, so as to synthesize a protein of interest. The synthetic reaction solution comprises the aforementioned cell-free extract, template RNA, labeled and non-labeled amino acids used as substrates, an energy source, various types of ions, a buffer solution, an ATP regenerative system, a nuclease inhibitor, tRNA, a reducing agent, polyethylene glycol, 3',5'-cAMP, folate, an antibacterial agent, and the like. These components are selected and prepared, as appropriate, depending on the type of a protein of interest.

The concentration of a substrate is preferably between 0.05 and 0.4 mM. Examples of an energy source may include ATP and GTP. 1.0 to 1.5 mM ATP is preferably added, and 0.2 to 0.3 mM GTP is preferably added. Examples of various types of ions and a suitable concentration thereof in the reaction solution may include: 60 to 120 mM potassium acetate; and 1 to 10 mM magnesium acetate. Examples of a buffer solution used herein may include: 15 to 35 mM Hepes-KOH; and 10 to 50 mM Tris-acetic acid. In addition, examples of an ATP regenerative system may include: the combination of phosphoenol pyruvate with kinase pyruvate; and the combination of 12 to 20 mM creatine phosphoric acid (creatine phosphate) with 0.2 to 1.6 µg/µl creatine kinase. Examples of a nuclease inhibitor may include: a ribonuclease inhibitor of 0.3 to 3.0 U per µl of the reaction solution; and a nuclease inhibitor of 0.3 to 3.0 U per µl of the reaction solution.

Among these inhibitors, a specific example of the ribonuclease inhibitor is RNase inhibitor derived from human placenta (manufactured by TOYOBO). Moreover, tRNA can be obtained by the method described in Moniter, R., et al., Biochim. Biophys. Acta., 43, 1 (1960), etc., or a commercially available product can also be used. An example of a reducing agent is 0.1 to 3.0 mM dithiothreitol. Examples of an antibacterial agent may include 0.001% to 0.01% sodium azide and 0.1 to 0.2 mg/ml ampicillin. An example of a nucleic acid stabilizer is 0.3 to 0.5 mM spermidine.

A temperature applied for the synthesis is between 10°C and 40°C, preferably between 15°C and 30°C, and more preferably between 20°C and 26°C. The reaction time is not particularly limited, as long as a protein can be synthesized. If a system for supplying a substance that is consumed during a translation reaction is used as in the present invention, the reaction is maintained for 24 to 75 hours.

Examples of a system or device for protein synthesis may include: a method involving addition of an energy source, amino acids, or tRNA, necessary for the cell-free protein synthesis, to the cell extract, as with the batch method (Pratt, J. M. et al., Transcription and Translation, Hames, 179-209, B. D. & Higgins, S. J., eds, IRL Press, Oxford (1984)); a continuous cell-free protein synthetic system for supplying amino acids, an energy source, or the like, to the reaction system (Spirin, A. S. et al., Science, 242, 1162-1164 (1988)); the dialysis method (Kikawa et al., the 21^{st} Annual Meeting of the Molecular Biology Society of Japan, WID6); and the double layer method (Sawasaki, T., et al., FEBS Let., 514, 102-105 (2002)). Moreover, a method of supplying template RNA, amino acids, an energy source, or the like, to the synthetic reaction system when necessary, and then discharging the synthetic product or the decomposed product when necessary (Japanese Patent Application Laid-Open No. 2000-333673; hereinafter referred to as a "discontinuous gel filtration method" at times), or other methods, can also be applied.

### (4-2) Recovery and purification of protein of interest

The thus synthesized protein of interest can be obtained by recovering it from the reaction solution, and then purifying it by a suitable method as necessary. However, when such a protein of interest is used for the NMR measurement, purification is not always necessary. In many cases, it is sufficient that the protein of interest be concentrated to a suitable concentration by a known method, and that a buffer solution be exchanged with a solution used for the NMR measurement. An example of a concentration method is a method using an ultrafiltration concentration device. In addition, for the exchange of a buffer solution, a method using a commercially available spin column or the like is preferably used.

### (5) NMR measurement

The thus synthesized protein of interest is subjected to the NMR measurement by the method according to (1) above, and the obtained signals are then compared, so as to determine the assignment of the signals. Regardless of solution or solid, any type of NMR measurement method can be used herein, as long as it is a method usable for NMR. Specifically, any type of heteronuclear multi-dimensional NMR measurement method can be used. Examples of such an NMR measurement method may include HSQC, HMQC, CH-COSY, CBCANH, CBCA(CO)NH, HNCO, HN(CA)CO, HNHA, H(CACO)NH, HCACO, ¹⁵N-edited NOESY-HSQC, ¹³C-edited NOESY-HSQC, ¹³C/¹⁵N-edited HMQC-NOESY-HMQC, ¹³C/¹³C-edited HMQC-NOESY-HMQC, ¹⁵N/¹⁵N-edited HSQC-NOESY-HSQC (Cavanagh, W.J., et al., Protein NMR Spectroscopy. Principles and Practice, Academic Press (1996)), HN(CO)CACB, HN(CA)CB, HN(COCA)CB (Yamazaki, T., et al., J. Am. Chem. Soc., 116 (1994) 11655-11666), H(CCO)NH, C(CO)NH (Grzesiek, S., et al., J. Magn. Reson., B 101 (1993) 114-119), CRIPT, CRINEPT (Riek, R., et al., Proc. Natl. Acad. Sci. USA., 96 (1999) 4918-4923), HMBC, HBHA(CBCACO)NH (Evans J. N. S., Biomolecular NMR Spectroscopy. Oxford University Press (1995) 71), INEPT (Morris, G. A., et al., J. Am. Chem. Soc., 101 (1979) 760-762), HNCACB (Wittekind, M., et al., J. Magn. Reson. B 101 (1993) 201), HN(CO)HB (Grzesiek, S., et al., J. Magn. Reson. 96 (1992) 215-222), HNHB (Archer, S. J., et al., J. Magn. Reson., 95 (1991) 636-641), HBHA(CBCA)NH (Wang, A.C., et al., J. Magn. Reson., B 105 (1994) 196-198), HN(CA)HA (Kay, L.E., et al., J. Magn. Reson., 98 (1992) 443-450), HCCH-TOCSY (Bax, A., et al., J. Magn. Reson., 88 (1990) 425-431), TROSY (Pervushin, K., et al., Proc. Natl. Acad. Sci., 94 (1997) 12366-12371), ¹³C/¹⁵N-edited HMQC-NOESY-HSQC (Jerala R, et al., J.Magn. Reson., 108 (1995) 294-298), HN(CA)NH (Ikegami, T., et al., J. Magn. Reson., 124 (1997) 214217), and HN(COCA)NH (Grzesiek, S., et al., J. Biomol. NMR, 3 (1993) 627-638), but examples are not limited thereto.

Among these methods, the two-dimensional NMR methods such as HSQC or HMQC, and the modified two-dimensional methods obtained by omitting one dimension from the three-dimensional NMR methods such as HNCO, HNCA, or HN(CO)CA, are preferably used.

In addition, the four measurement methods, namely, HN(CO), HN(CA), H(N)CA, and H(NCO)CA, were used as the aforementioned measurement methods. However, it is also possible to obtain the same spectra as those in the case of HN(CO) or HN(CA), using the isotope filter method (Breeze, A. L., Prog. NMR Spectroscopy, 36 (2000) 323-372), instead of HN(CO) or HN(CA). Moreover, the anteroposterior relationship of amino acids can be specified by using the combination of H(N)CO with H(NCA)CO, instead of H(N)CA and HN(NCO)CA. However, in such a case, since H(NCA)CO has low measurement sensitivity, it is preferable that the hydrogen atom at position 2 (position α) of the protein of interest be substituted with deuterium (Gardner, K. H. and Kay, L. E., Annu. Rev. Biophys. Biomol. Struct., 27 (1998) 357-406). Furthermore, in the case of a protein having a molecular weight of larger than 20,000, the aforementioned measurement method is substituted with a similar measurement method using the TROSY effect (Pervushin, K., et al., Proc. Natl. Acad. Sci., 94 (1997) 12366-12371), so as to suppress a decrease in the sensitivity. Further, it is also effective to substitute hydrogen atoms other than the amide hydrogen atom in the main chain with deuterium atoms (Gardner, K. H. and Kay, L. E., Annu. Rev. Biophys. Biomol. Struct., 27 (1998) 357-406).

### (6) Three-dimensional structure analysis method

The present method does not only enable determination of the assignment of all signals of the ¹H-¹⁵N HSQC spectrum, but also simultaneously determines the chemical shifts of all the carbon atoms at position 2. Moreover, by adding the two-dimensional measurement such as H(N)CO, CBCA(CON)H, or HBHA(CBCACO)NH, the chemical shifts of all carbonyl carbons, the chemical shift of β carbon, and the chemical shift of αβ hydrogen of a protein of interest can be measured in principle. Using such information, the two-dimensional structure of a protein of interest can be assumed by applying the chemical shift index method (Wishart, D. and Case, D. A., Methods in Enzymol. 338 (2001) 3-34). Furthermore, by adding a measurement such as HCCH or TOCSY, the chemical shifts of carbon atoms, nitrogen atoms, hydrogen atoms including side chains can be determined. Using such information, the three-dimensional structure of a protein of interest can be determined according to a common method (Cavanagh, W. J., et al., Protein NMR Spectroscopy. Principles and Practice, Academic Press (1996)). Still further, determination of the assignment of all signals of the ¹H-¹⁵N HSQC enables the measurement by the residual dipolar coupling method (Bax et al., Methods in Enzymol. 339 (2001) 127-174), so as to obtain the three-dimensional structure information of a protein of interest.

### (7) Method of identifying the binding site of protein to ligand

A protein of interest and a complex consisting of the protein of interest and the ligand thereof are subjected to the NMR measurement. Thereafter, the obtained signals are compared with one another, and the assignment of signals whose chemical shift has been changed is determined by the methods described in (1) to (5) above, thereby determining the binding site of a protein of interest to the ligand thereof. It can be determined that amino acids represented by the above signals whose chemical shift has been changed are at least the binding sites of ligands to the protein of interest.

### (8) Reagent kit used for signal assignment method

A reagent kit which comprises one or more types of amino acids wherein at least the carbon atoms at positions 2 and 1 have been labeled with ¹³C and the nitrogen atom at position 2 has been labeled with ¹⁵N, and multiple amino acids wherein the nitrogen atom at position 2 has been labeled with ¹⁵N and the carbon atoms at position 2 and 1 have not been labeled with ¹³C, is provided to carry out the assignment method of the present invention. The constitutional components of the present kit are not limited to the aforementioned amino acids. In addition to the aforementioned amino acids, the present kit may also comprise one or more types of amino acids wherein the carbon atoms at positions 1 and/or 2 have been labeled with ¹³C, a wheat germ extract for the cell-free protein synthesis described in (4-1) above, a reagent necessary for the above synthetic system, a buffer solution used for the NMR measurement, and the like. In particular, when the reagent kit comprises a wheat germ extract, it is preferable that the kit also comprise an amino acid metabolic inhibitor necessary for the above cell-free protein synthetic system. Specific examples may include a transaminase inhibitor and a glutamine synthesis inhibitor, which are described in (4-1) above.

### EXAMPLES

The present invention will be described in the following examples. However, these examples are not intended to limit the scope of the present invention.

### Example 1 NMR measurement of protein of interest synthesized using substrate wherein only one type of amino acid has been double-labeled with ¹³C/¹⁵N and 19 types of other amino acids have been labeled with only ¹⁵N

### (1) Preparation of template mRNA

The gene (Genbank accession No. M54881) of an *Escherichia coli* thioredoxin protein (the amino acid sequence thereof is shown in SEQ ID NO: 3 of the sequence listing) was amplified by the PCR method, using, as a template, *Escherichia coli* genomic DNA prepared from the *Escherichia coli* K-12 strain using MagPrep Bacterial Genomic DNA Kit (Novagen), and also using primers having the nucleotide sequences shown in SEQ ID NOS: 1 and 2. The amplified gene was introduced into the Spe I - Sal I site of a plasmid pEU3b (Sawasaki, T., Proc. Natl. Acad. Sci. USA., 99(23), 14652-14657 (2002)). Using the above plasmid as a template, the mRNA of the *Escherichia coli* thioredoxin protein was transcribed with SP6 RNA polymerase (manufactured by Promega) in the presence of 16 mM magnesium ions, and was then synthesized.

### (2) Synthesis of protein of interest using substrate wherein all amino acids have been labeled with ¹⁵N

The mRNA synthesized in Example 1 above was concentrated to 100 µg/130 µl, and the concentrated mRNA was then mixed with a wheat germ extract (Proteios™, manufactured by TOYOBO) (2 ml). The mixed solution was allowed to react for 2 days with a dialysis buffer solution (manufactured by Cambridge Isotope Laboratories), wherein all 20 types of amino acids had been labeled with ¹⁵N. Thereafter, the dialysis buffer solution was exchanged with a fresh solution, and a protein synthetic reaction was further carried out for 2 days. Thereafter, 2 ml of the reaction solution was concentrated to 250 µ 1 using a Centricon-3 ultrafiltration concentration device manufactured by Millipore. The obtained concentrate contained a 100 µM *Escherichia coli* thioredoxin protein. The concentrate was passed through a Micro Spin G-25 gel filtration column manufactured by Amersham, which had previously been equilibrated with an NMR measurement buffer solution (50 mM sodium phosphate (pH 6.0), 100 mM NaCl), so as to exchange with the measurement buffer solution, thereby obtaining an NMR measurement sample.

### (3) Synthesis of protein of interest using substrate wherein only one type of amino acid has been labeled with ¹⁵N

The mRNA synthesized in Example 1 above was concentrated to 100 µg/130 µl, and the concentrated mRNA was then mixed with a wheat germ extract (Proteios™, manufactured by TOYOBO) (2 ml). The mixed solution was allowed to react for 2 days with a dialysis buffer solution, wherein only one type of amino acid had been labeled with ¹⁵N (manufactured by Cambridge Isotope Laboratories) and the remaining 19 types of amino acids were ordinary amino acids. Thereafter, the dialysis buffer solution was exchanged with a fresh solution, and a protein synthetic reaction was further carried out for 2 days. In order to inhibit amino acid conversion due to amino acid metabolic enzyme, aminoxyacetic acid and L-methionine sulfoximine were added to the external dialyzing fluid, resulting in final concentrations of 1 mM and 0.1 mM, respectively. Thereafter, 2 ml of the reaction solution was concentrated to 250 µ l using a Centricon-3 ultrafiltration concentration device manufactured by Millipore. The obtained concentrate contained a 100 µM *Escherichia coli* thioredoxin protein. The concentrate was passed through a Micro Spin G-25 gel filtration column manufactured by Amersham, which had previously been equilibrated with an NMR measurement buffer solution (50 mM sodium phosphate (pH 6.0), 100 mM NaCl), so as to exchange with the measurement buffer solution, thereby obtaining an NMR measurement sample.

### (4) Synthesis of protein of interest using substrate wherein only one type of amino acid has been double-labeled with ¹³C/¹⁵N and 19 types of other amino acids have been labeled with only ¹⁵N

The mRNA synthesized in Example 1 above was concentrated to 100 µg/130 µl, and the concentrated mRNA was then mixed with a wheat germ extract (Proteios™, manufactured by TOYOBO) (2 ml). The mixed solution was allowed to react for 2 days with a dialysis buffer solution, wherein only one type of amino acid had been double-labeled with ¹³C/¹⁵N (manufactured by Cambridge Isotope Laboratories) and the nitrogen atoms of the amides of the remaining 19 types of amino acids had been labeled with ¹⁵N and have not been labeled with ¹³C. Thereafter, the dialysis buffer solution was exchanged with a fresh solution, and a protein synthetic reaction was further carried out for 2 days. In order to inhibit amino acid conversion due to amino acid metabolic enzyme, aminoxyacetic acid and L-methionine sulfoximine were added to the external dialyzing fluid, resulting in final concentrations of 1 mM and 0.1 mM, respectively. Thereafter, 2 ml of the reaction solution was concentrated to 250 µl using a Centricon-3 ultrafiltration concentration device manufactured by Millipore. The obtained concentrate contained a 100 µM *Escherichia coli* thioredoxin protein. The concentrate was passed through a Micro Spin G-25 gel filtration column manufactured by Amersham, which had previously been equilibrated with an NMR measurement buffer solution (50 mM sodium phosphate (pH 6.0), 100 mM NaCl), so as to exchange with the measurement buffer solution, thereby obtaining an NMR measurement sample.

### (5) NMR measurement

Avance-500 spectrometer manufactured by Bruker was used for the NMR measurement. 5% D₂O was added to a measurement sample for NMR lock to maintain the stability of a magnetic field, and then measurement was carried out. The measurement temperature was set at 35°C.

First, the ¹H-¹⁵N HSQC spectrum of an *Escherichia coli* thioredoxin protein, which had been synthesized using a substrate wherein all amino acids had been labeled with ¹⁵N (Figure 3).

Only one type of amino acid (out of the 19 types of amino acids except for proline) was labeled with ¹⁵N, and the other amino acids were not labeled, so as to synthesize *Escherichia coli* thioredoxin proteins. Thereafter, the ¹H-¹⁵N HSQC spectrum of each protein was measured. From these spectra, the type of an amino acid from which each signal of the ¹H-¹⁵N HSQC spectra of the *Escherichia coli* thioredoxin proteins all labeled with ¹⁵N is derived, could be understood.

In addition, *Escherichia coli* thioredoxin proteins (total 20 types), wherein only one type of amino acid had been double-labeled with ¹³C/¹⁵N by the method described in (4) above and 19 types of the other amino acids had been labeled with only ¹⁵N, were subjected to the following measurements: HN(CO) (two-dimensional measurement obtained by omission of the developing time of CO from the HNCO three-dimensional measurement method described in Cavanagh, W. J., et al., Protein NMR Spectroscopy. Principles and Practice, Academic Press(1996)); HN(CA) (two-dimensional measurement obtained by omission of the developing time of CA from the HNCA three-dimensional measurement method described in Cavanagh, W. J., et al., Protein NMR Spectroscopy. Principles and Practice, Academic Press (1996)); H(N)CA (two-dimensional measurement obtained by omission of the developing time of N from the HNCA three-dimensional measurement method described in Cavanagh, W. J., et al., Protein NMR Spectroscopy. Principles and Practice, Academic Press (1996)); and H(NCO)CA (two-dimensional measurement obtained by omission of the developing time of N from the HN(CO)CA three-dimensional measurement method described in Cavanagh, W. J., et al., Protein NMR Spectroscopy. Principles and Practice, Academic Press (1996)).

The HN(CO) spectrum of each of *Escherichia coli* thioredoxin proteins (total 20 types), wherein only one out of 20 types of amino acids that constitute a protein had been double-labeled with ¹³C/¹⁵N and 19 types of the other amino acids had been labeled with ¹⁵N, was measured. Of these HN(CO) spectra, in the HN(CO) spectrum (Figure 4) of an *Escherichia coli* thioredoxin protein wherein only alanine had been labeled with ¹³C/¹⁵N and 19 types of the other amino acids have been labeled with ¹⁵N, for example, only the correlation signal of the amide HN of an amino acid residue located immediately after the alanine were observed. Likewise, in the case of the following 19 types as well, only the NH correlation signal of the amino acid residue located immediately after the double-labeled amino acid residue is observed.

Moreover, when each of the aforementioned 20 types of proteins was subjected to the NH(CA) measurement, only the HN correlation signal of the double-labeled amino acid residue with an amino acid residue located immediately after the double-labeled amino acid residue is observed.

Furthermore, when each of the aforementioned 20 types of proteins was subjected to the H(NCO)CA measurement, only the correlation signal of the amide hydrogen atom of an amino acid residue located immediately after the double-labeled amino acid residue with the carbon atom at position α of the double-labeled amino acid residue is observed. Still further, when each of the aforementioned 20 types of proteins was subjected to the H(N)CA measurement, only the correlation signal of the amide hydrogen atom of an amino acid residue located immediately after the double-labeled amino acid residue with the carbon atom at position α of the double-labeled amino acid residue, and the correlation signal of the amide hydrogen atom of the double-labeled amino acid residue with the carbon atom at position α of the double-labeled amino acid residue, are observed.

### (6) Method of determining assignment of each signal amino acid residue number of ¹H-¹⁵N HSQC (Method 1)

As a first example, the assignment of the ¹H-¹⁵N HSQC signals of 4 phenylalanine residues (F12, F27, F81, and F102) contained in *Escherichia coli* thioredoxin will be described. First, the positions of 4 signals derived from the phenylalanine residues are determined from the ¹H-¹⁵N HSQC spectrum (Figure 5a) of an *Escherichia coli* thioredoxin protein, wherein only the phenylalanine residues have been labeled with ¹⁵N. Subsequently, residues (S11, D26, L80, and E101) located immediately before the 4 phenylalanine residues are focused (refer to Figure 1A).

Only the ¹H-¹⁵N correlation signal of the amide located immediately after serine is observed in the HN(CO) spectrum (Figure 5b) of an *Escherichia coli* thioredoxin protein wherein only the serine residue has been double-labeled with ¹³C/¹⁵N and 19 types of the other amino acids have been labeled with ¹⁵N. Thus, it can be confirmed that the signal whose position is the same in Figures 5a and 5b is a phenylalanine residue located immediately after the serine. Since the phenylalanine residue that satisfies such condition is only F12 in the amino acid sequence of the *Escherichia coli* thioredoxin protein (Figure 1A), it can be determined that the corresponding signal is derived from F12.

Likewise, in the ¹H-¹⁵N HSQC spectrum (Figure 6a) of an *Escherichia coli* thioredoxin protein wherein only the phenylalanine residue has been labeled with ¹⁵N, and in the HN(CO) spectrum (Figure 6b) of an *Escherichia coli* thioredoxin protein wherein only the aspartic acid residue has been double-labeled with ¹³C/¹⁵N and 19 types of the other amino acids have been labeled with only ¹⁵N, only the corresponding signal is one derived from a phenylalanine residue located immediately after the aspartic acid (refer to Figure 1A). Thus, it can be confirmed that the signal is derived from F27. Moreover, similarly, in the ¹H-¹⁵N HSQC spectrum (Figure 7a) of an *Escherichia coli* thioredoxin protein wherein only the phenylalanine residue has been labeled with ¹⁵N, and in the HN(CO) spectrum (Figure 7b) of an *Escherichia coli* thioredoxin protein wherein only the leucine residue has been double-labeled with ¹³C/¹⁵N and 19 types of the other amino acids have been labeled with only ¹⁵N, only the corresponding signal is one derived from a phenylalanine residue located immediately after the leucine (refer to Figure 1A), namely, one derived from F81. Likewise, in the ¹H-¹⁵N HSQC spectrum (Figure 8a) of an *Escherichia coli* thioredoxin protein wherein only the phenylalanine residue has been labeled with ¹⁵N, and in the HN(CO) spectrum (Figure 8b) of an *Escherichia coli* thioredoxin protein wherein only the glutamic acid residue has been double-labeled with ¹³C/¹⁵N and 19 types of the other amino acids have been labeled with only ¹⁵N, only the corresponding signal is one derived from a phenylalanine residue located immediately after the glutamic acid (refer to Figure 1A). Thus, it can be determined that the signal is derived from F102.

With regard to other amino acid residues, the positions of signals in the ¹H-¹⁵N HSQC spectrum can be determined by the totally same method.

The above-described method can be applied to all amino acid residues, regarding which the alignment of two amino acid residues appears only once in the amino acid sequence of an *Escherichia coli* thioredoxin protein.

### (7) Method of determining assignment of each signal amino acid residue number of ¹H-¹⁵N HSQC (Method 2)

By applying the above-described method, the amino acid residue numbers of 75% of signals can be specified in the ¹H-¹⁵N HSQC spectrum of an *Escherichia coli* thioredoxin protein. However, with respect to the remaining amino acids, their amino acid residue numbers cannot be specified by the above-described method. An assignment method applied in such a case will be described below.

When the method described in Example (6) above is applied to determine the assignment of an isoleucine residue in the ¹H-¹⁵N HSQC spectrum of an *Escherichia coli* thioredoxin protein, it causes the following problems.

When the ¹H-¹⁵N HSQC spectrum (Figure 9(a)) of an *Escherichia coli* thioredoxin protein wherein only the isoleucine residue has been labeled with ¹⁵N is compared with the HN(CO) spectrum (Figure 9(b)) of an *Escherichia coli* thioredoxin protein wherein only the glycine residue has been double-labeled with ¹³C/¹⁵N and 19 types of the other amino acids have been labeled with only ¹⁵N, there are two corresponding signals. This is because there are two isoleucine residues, I72 and I75, located immediately after the glycine residue (refer to Figure 2A). In this case, it is impossible for the method described in Example (6) above to determine which one of such two signals is derived from I72 or I75. Thus, in this case, first, the positions of G71 located immediately before I72, and G74 are determined by the method in Example (6) (Figure 10(a)). Thereafter, the H(N)CA spectrum and H(NCO)CA spectrum of an *Escherichia coli* thioredoxin protein wherein only the glycine residue has been double-labeled with ¹³C/¹⁵N and 19 types of the other amino acids have been labeled with only ¹⁵N, are used. The chemical shift of an amide hydrogen atom can be determined from the previously determined ¹H-¹⁵N signal of G71. From among signals on the H(N)CA spectrum, a signal to which the position of the amide hydrogen atom corresponds is determined (Figure 10(b)). Since such signals indicate the chemical shift correlation of the amide hydrogen atom of G71 with an α carbon atom thereof, the chemical shift of the α carbon atom of G71 can be determined. Subsequently, a signal having the same chemical shift as that of an α carbon atom is determined from the H(NCO)CA spectrum (Figure 10c). H(NCO)CA indicates the correlation of the chemical shift of the amide hydrogen atom of 172 with the chemical shift of the α carbon atom of G71, the chemical shift of the amide hydrogen atom of 172 can be determined. Thus, if the ¹H-¹⁵N signal of isoleucine having the same chemical shift as that of the amide hydrogen atom of 172 is determined from the ¹H-¹⁵N HSQC spectrum of an *Escherichia coli* thioredoxin protein wherein only the isoleucine residue has been labeled with ¹⁵N, it can be determined that this signal is a signal of 172 (Figure 10d). The assignment of I75 can also be determined in the completely same manner.

By applying the completely same above method to other amino acid residues, the assignment of signals having the same alignment of amino acids can also be determined uniquely. This method is used with the combination of the method described in Example (6) above, so that the assignment of almost all the signals in the ¹H-¹⁵N HSQC of an *Escherichia coli* thioredoxin protein, including the residue numbers thereof, could be determined (Figure 11).

### (8) Method of determining assignment of each signal amino acid residue number of ¹H-¹⁵N HSQC (Method 3)

In order to determine the assignment of all the signals in the ¹H-¹⁵N HSQC using the methods described in Examples (6) and (7) above, it has been necessary to prepare 19 types of *Escherichia coli* thioredoxin proteins (the HSQC signal of a proline residue cannot be observed) wherein only one type of amino acid residue has been labeled with ¹⁵N, and 20 types of *Escherichia coli* thioredoxin proteins wherein only one type of amino acid residue has been double-labeled with ¹³C/¹⁵N and 19 types of the other amino acids have been labeled with only ¹⁵N. However, if the following method is applied, such 19 types of *Escherichia coli* thioredoxin proteins wherein only one type of amino acid residue has been labeled with only ¹⁵N become unnecessary.

Using a phenylalanine residue as an example, a method of obtaining the same information as that obtained from the ¹H-¹⁵N HSQC spectrum (Figure 12c) of an *Escherichia coli* thioredoxin protein wherein only the phenylalanine residue has been labeled with ¹⁵N, using an *Escherichia coli* thioredoxin protein wherein only the phenylalanine residue has been double-labeled with ¹³C/¹⁵N and 19 types of the other amino acids have been labeled with only ¹⁵N, will be described. From the HN(CA) spectrum (Figure 12a) of an *Escherichia coli* thioredoxin protein wherein only the phenylalanine residue has been double-labeled with ¹³C/¹⁵N and 19 types of the other amino acids have been labeled with only ¹⁵N, the ¹H-¹⁵N signals of the phenyl alanine residue and an amino acid residue located immediately after the phenylalanine residue can be obtained. On the other hand, from the HN(CO) spectrum of the same protein (Figure 12b), the ¹H-¹⁵N signal of an amino acid residue located immediately after the phenylalanine residue can be obtained. Accordingly, all signals in the HN(CA) spectrum, from which signals also existing in the HN(CO) spectrum are eliminated, are the ¹H-¹⁵N signal of the phenylalanine residue, and such a signal is completely the same as that obtained from the ¹H-¹⁵N HSQC spectrum of an *Escherichia coli* thioredoxin protein wherein only the phenylalanine residue has been labeled with ¹⁵N. Similarly, information obtained from the ¹H-¹⁵N HSQC spectrum of an *Escherichia coli* thioredoxin protein wherein only a certain amino acid residue has been labeled with ¹⁵N, can easily be obtained by comparing the HN(CA) spectrum of an *Escherichia coli* thioredoxin protein wherein the certain amino acid residue has been double-labeled with ¹³C/¹⁵N and 19 types of the other amino acids have been labeled with only ¹⁵N, with the HN(CO) spectrum thereof.

### (9) Method of determining assignment of each signal amino acid residue number of ¹H-¹⁵N HSQC (Method 4)

Several methods of determining the assignment of signals of the ¹H-¹⁵N HSQC spectrum are described in Examples (6), (7), and (8) above. The procedures of actually determining all signals are as follows.
(a) From the 19 types of HSQC spectra of *Escherichia coli* thioredoxin proteins wherein only one type of amino acid residue has been labeled with ¹⁵N, or from the HN(CO) and HN(CA) spectra of an *Escherichia coli* thioredoxin protein wherein only one type of amino acid residue has been double-labeled with ¹³C/¹⁵N and 19 types of the other amino acids have been labeled with only ¹⁵N, the type of an amino acid, to which each signal in the ¹H-¹⁵N HSQC spectrum is assigned, is determined.
(b) From the HN(CO) spectrum of an *Escherichia coli* thioredoxin protein wherein only one type of amino acid residue has been double-labeled with ¹³C/¹⁵N and 19 types of the other amino acids have been labeled with only ¹⁵N, the type of an amino acid, after which a residue from which each signal is derived is located, is determined.
(c) From the amino acid sequence listing (as shown in Table 1, it is convenient, if a list, on which the type of an amino acid that is suitably located after each amino acid is described, is prepared), the assignment of signals is determined using the alignment of amino acids.
(d) In a case where the same alignment of continuous amino acids is found at two or more sites, using the H(N)CA and H(NCO)CA spectra, the assignment is determined from residues located frontward, whose assignment has been determined. When the assignment of such residues located frontward is uncertain under the same circumstances, assignment is successively determined from residues located further frontward.

**Table 1**

| | | | | | | | | | | | | | |
|---|---|---|---|---|---|---|---|---|---|---|---|---|---|
| A | A19 *D20 | A22 I23 | A29 E30 | A39 #P40 | A46 *D47 | A56 K57 | A67 #P68 | A87 A88 | A88 T89 | A93 L94 | A105 N106 | A108 C-ter | |
| C | C32 G33 | C35 K36 | | | | | | | | | | | |
| D | D2 K3 | D9 D10 | D10 S11 | D13 T14 | D15 V16 | D20 G21 | D26 F27 | D43 *E44 | D47 *E48 | D61 Q62 | D104 A105 | | |
| E | E30 W31 | E44 145 | E48 Y49 | E85 V86 | E101 F102 | | | | | | | | |
| F | F12 D13 | F27 W28 | F81 K82 | F102 L103 | | | | | | | | | |
| G | G21 *A22 | G33 #P34 | G51 K52 | G65 T66 | G71 *I72 | G74 *175 | G84 EB5 | G92 *A93 | G97 Q98 | | | | |
| H | H6 L7 | | | | | | | | | | | | |
| I | 14 15 | 15 H6 | 123 *L24 | I38 *A39 | I41 *L42 | I45 *A46 | 160 D61 | 172 R73 | 175 #P76 | | | | |
| K | K3 I4 | K18 A19 | K36 M37 | K52 *L53 | K57 *L58 | K69 Y70 | K82 N83 | K90 V91 | K96 G97 | K100 E101 | | | |
| L | L7 *T8 | L17 *K18 | L24 V25 | L42 *D43 | L53 *T54 | L58 N59 | L78 *L79 | L79 *L80 | L80 F81 | L94 S95 | L99 *K100 | L103 *D104 | L107 A108 |
| M | M37 138 | | | | | | | | | | | | |
| N | N59 I60 | N63 #P64 | N83 G84 | N106 L107 | | | | | | | | | |
| P | P34 C35 | P40 141 | P64 G65 | P68 K69 | P76 T77 | | | | | | | | |
| Q | Q50 G51 | Q62 N63 | Q98 L99 | | | | | | | | | | |
| R | R73 G74 | | | | | | | | | | | | |
| S | S1 D2 | S11 F12 | S95 K96 | | | | | | | | | | |
| T | T8 *D9 | T14 *D15 | T54 V55 | T66 A67 | T77 L78 | T89 K90 | | | | | | | |
| V | V16 L17 | V25 D26 | V55 *A56 | V86 *A87 | V91 G92 | | | | | | | | |
| W | W28 A29 | W31 C32 | | | | | | | | | | | |
| Y | Y49 Q50 | Y70 G71 | | | | | | | | | | | |

### (10) Method of determining assignment of each signal amino acid residue number of ¹H-¹⁵N HSQC (Method 5)

An *Escherichia coli* thioredoxin protein, wherein only one type of residue has been double-labeled with ¹³C/¹⁵N and 19 types of the other amino acids have been labeled with only ¹⁵N, was used in Examples (6), (7), (8), and (9) described above. However, it is not necessary that all amino acids other than the double-labeled amino acid residue be always labeled with ¹⁵N. First of all, since the ¹H-¹⁵N HSQC signal cannot originally be observed from the proline residue, it is not necessary that the proline residue be labeled with ¹⁵N. In addition, in the case of double-labeling the tryptophan residues (W28 and W31) with ¹³C/¹⁵N, for example, amino acids located after the cysteine residue are only the alanine residue (A29) and the cysteine residue (C32) in an *Escherichia coli* thioredoxin protein. Thus, in this case, the same results as those obtained in the aforementioned examples can be obtained even by double-labeling only the tryptophan residue with ¹³C/¹⁵N, labeling the alanine residue and the cysteine residue with only ¹⁵N, and using non-labeled amino acids as other amino acids. In other words, it is sufficient that only amino acid located after the double-labeled amino acid be labeled with ¹⁵N.

Signals obtained from the HN(CO) and HN(CA) spectra were used for analysis in the aforementioned Examples (6) and (8). These measurement methods are methods of measuring the ¹H-¹⁵N correlation signal of an amino acid adjacent to the double-labeled amino acid. However, in order to identify the ¹H-¹⁵N correlation signal of an amino acid adjacent to the double-labeled amino acid, the following measurement method can be applied. When the isotopic filter method (Breeze, A. L., Prog. NMR Spectroscopy, 36 (2000) 323-372) is used in the ¹H-¹⁵N HSQC measurement method, the signal of ¹⁵N adjacent to ¹³C can be eliminated. The results obtained by this measurement are shown in Figure 13b. As is shown in Figure 13b, when this isotopic filter method is applied to an *Escherichia coli* thioredoxin protein wherein only phenylalanine has been double-labeled with ¹³C/¹⁵N and all other amino acids have been labeled with ¹⁵N, the ¹H-¹⁵N correlation signals of all amino acid residues that are not adjacent to the phenylalanine residue can be obtained. These signals are compared with the ¹H-¹⁵N HSQC spectrum (Figure 13a) of an *Escherichia coli* thioredoxin protein wherein all amide nitrogen atoms in the main chain have been labeled with ¹⁵N. Signals that disappear in Figure 12b are identical to the signals obtained in the HN(CO) spectrum of the same sample (Figure 13c). In the case of the HN(CA) spectrum as well, the ¹H-¹⁵N correlation signal of an amino acid residue adjacent to the amino acid, the position 2 (position α) of which is labeled with ¹³C, can be identified by the same method. In the case of using this measurement method, it is preferable that all amino acids other than the double-labeled amino acids of a protein of interest have been labeled with ¹⁵N.

### INDUSTRIAL APPLICABILITY

The method of the present invention enables reduction in the total measurement time or an increase in sensitivity as a result of an increase in the accumulated time, using only the two-dimensional NMR measurement method involving a measurement time that is significantly shorter than that of the three-dimensional NMR measurement method. In addition, all information necessary for determination of the assignment of the ¹H-¹⁵N signals can be obtained by such necessary two-dimensional NMR measurement method, using only 4 types of spectra, HN(CO), HN(CA), H(N)CA, and H(NCO)CA, which have high sensitivity that is a half or more of the sensitivity of ¹H-¹⁵N HSQC. As a result, necessary assignment information can be obtained using a protein sample with a concentration that is approximately 1 to 2 times higher than that of a protein sample necessary for the ¹H-¹⁵N HSQC measurement method. Moreover, since approximately 20 types of protein samples are prepared and they are successively measured according to the method of the present invention, the measurement time required for a single sample is reduced to one twentieth or less of that of the conventional method. Accordingly, the assignment of the signals of the ¹H-¹⁵N HSQC spectrum can be determined even in the case of an unstable protein sample, which cannot be sustained at a temperature higher than room temperature for several weeks.

According to the method of the present invention, the assignment of all the signals of the ¹H-¹⁵N HSQC spectrum can be determined only by analyzing a simple two-dimensional NMR spectrum. When the present inventors actually determined such assignment, the analysis time required for determination of the assignment is one twentieth or less of that of the conventional method. In addition, the present invention is also characterized in that people who are not so skilled can also make such analysis.

From the assignment information obtained by the present invention, information regarding the chemical shifts of various atoms of amino acid residues, which mainly constitute the main chain of a protein, can be obtained. Thus, it also becomes possible to estimate the secondary structure of a protein of interest. Further, by combining the present measurement method with other measurement methods, it becomes possible to use it for determination of the three-dimensional structure.

Still further, the method of the present invention is advantageous to identify the binding site of a protein of interest to a ligand thereof. According to the method of the present invention, simple production of a sample with a low concentration and reduction in the NMR measurement time have been realized, and it has also become possible to carry out ligand screening including identification of the binding site of an unstable protein with low solubility to a ligand.

The present application claims priority from Japanese Patent Application (Japanese Patent Application No. 2004-25592), filed on February 2, 2004; the disclosure of which is hereby incorporated by reference. In addition, the disclosures of the documents cited in the present specification are also hereby incorporated by reference.

## Claims

1. A method of determining the assignment of a signal obtained by the NMR measurement of a protein, which comprises:
(i) preparing a protein, wherein the carbon atom(s) at position 2 and/or at position 1 and the nitrogen atom at position 2 of either one of amino acids adjacent to an amino acid to be identified on the amino acid sequence of the protein have been double-labeled for the NMR measurement, and wherein any one of nitrogen, carbon, and hydrogen atoms at position 2 of at least the amino acid to be identified has been labeled for the NMR measurement;
(ii) performing on the above-described protein, the NMR measurement, which is capable of identifying only the correlation signal of the amide proton of an amino acid residue to be identified, adjacent to the double-labeled amino acid, with the labeled atom; and
(iii) comparing the above-described signal with the correlation signal of the amide proton of an amino acid residue to be identified with the labeled atom, which is obtained by the NMR measurement of a protein wherein any one of nitrogen, carbon, and hydrogen atoms at position 2 of the amino acid to be identified has been labeled, so as to determine the assignment of the signal of the amino acid to be identified.

2. A method of determining the assignment of a signal obtained by the NMR measurement of a protein, which comprises:
(i) preparing a protein, wherein the carbon atoms at positions 2 and 1 have been labeled with ¹³C and the nitrogen atom at position 2 has been labeled with ¹⁵N, with respect to either one of amino acids adjacent to an amino acid to be identified on the amino acid sequence of the protein, and wherein the nitrogen atom at position 2 of at least the amino acid to be identified has been labeled with ¹⁵N;
(ii) performing on the above-described protein, the NMR measurement, which is capable of identifying only the correlation signal of the amide proton of an amino acid residue to be identified, adjacent to the double-labeled amino acid, with ¹⁵N; and
(iii) comparing the above-described signal with the correlation signal of the amide proton of an amino acid residue to be identified with ¹⁵N, which is obtained by the NMR measurement of a protein wherein only the nitrogen atom at position 2 of an amino acid to be identified has been labeled with ¹⁵N, so as to determine the assignment of the signal of the amino acid to be identified.

3. A method of determining the assignment of a signal obtained by the NMR measurement of a protein, which comprises:
(a) determining the assignment with respect to either one of amino acids adjacent to an amino acid to be identified on the amino acid sequence of a protein according to the method of claim 2;
(b) preparing a protein, wherein the carbon atoms at positions 2 and 1 of the above-described amino acid have been labeled with ¹³C and the nitrogen atom at position 2 thereof has been labeled with ¹⁵N, and the nitrogen atom at position 2 of at least the amino acid to be identified has been labeled with ¹⁵N;
(c) performing on the above-described protein, the NMR measurement, which is capable of identifying only the correlation signal of the ¹³C of the double-labeled amino acid residue with the amide proton, and the correlation signal of the ¹³C of the double-labeled amino acid residue with the amide proton of the adjacent amino acid residue to be identified;
(d) obtaining the correlation signal of the amide protons of the amino acid to be identified and the above double-labeled amino acid with ¹⁵N;
(e) selecting from the signals obtained in (c) above, a signal having a chemical shift identical to the chemical shift of the amide protons of amino acids, whose assignment has been determined, in the signal obtained in (d) above;
(f) selecting from the signals obtained in (c) above, a signal having a chemical shift identical to the chemical shift of the ¹³C of the selected signal; and
(g) selecting from the signals obtained in (c) above, a signal having a chemical shift identical to the chemical shift of the amide proton of the selected signal, and then determining the assignment of the above-described signal, using the fact that the above signal is assigned to an amino acid adjacent to the amino acid whose assignment has been determined.

4. The method according to claim 3, wherein, in step (c), the NMR measurement is further carried out to identify only the correlation signal of the ¹³C of the double-labeled amino acid residue with the amide proton of the adjacent amino acid residue to be identified, and it is confirmed that the signal selected in step (f) overlaps the signal as obtained above.

5. A method of determining the assignment of a signal obtained by the NMR measurement of a protein, which comprises:
(i) preparing a protein, wherein the carbon atom at positions 1 of either one of amino acids adjacent to an amino acid to be identified on the amino acid sequence of the protein has been labeled with ¹³C and the nitrogen atoms at position 2 of multiple amino acids including the amino acid to be identified have been labeled with ¹⁵N;
(ii) performing on the above-described protein, the NMR measurement, which is capable of identifying only the correlation signal of the amide proton of the amino acid residue to be identified, adjacent to the ¹³C-labeled amino acid, with ¹⁵N; and
(iii) comparing the above-described signal with the correlation signal of the amide proton of the amino acid residue to be identified with ¹⁵N, which is obtained by the NMR measurement of a protein wherein the nitrogen atom at position 2 of only the amino acid to be identified has been labeled with ¹⁵N, so as to determine the assignment of the signal of the amino acid to be identified.

6. A method of determining the assignment of all signals obtained by the NMR measurement of a protein, which comprises repeating the method according to claim 1 or 5, or combining the method according to claim 3 with the method according to claim 4.

7. A method of determining the assignment of the correlation signal of the amide proton with ¹³C or the amide proton with ²H, obtained by the NMR measurement of a protein, which comprises:
(i) determining the assignment of the correlation signal of the amide proton of a protein with ¹⁵N by the methods according to any of claims 2 to 6;
(ii) preparing a protein, wherein the carbon atom(s) or hydrogen atom(s) at position 2 and/or at position 1 of an amino acid to be identified on the amino acid sequence of the above-described protein have been double-labeled for the NMR measurement;
(iii) obtaining the correlation signal of the amide proton in the amino acid to be identified with the carbon atom(s) or hydrogen atom(s) of the same amino acid, which have been labeled for the NMR measurement, with respect to the above-described protein; and
(iv) using, as an indicator, the fact that amide protons common in the correlation signal of the amide proton with ¹⁵N in (i) above and in the correlation signal of the amide proton with ¹³C or with ²H in (iii) above have the same chemical shift, and associating the correlation signal of the amide proton with ¹³C or with ²H, with the correlation signal of the above-described amide proton with ¹⁵N, so as to determine the assignment of the correlation signal of the amide proton with ¹³C or with ²H.

8. A method of identifying the three-dimensional structure of a protein, wherein the chemical shift information of the NMR signal whose assignment has been determined by the method according to claim 6 or 7 is used.

9. A method of identifying the binding site of a protein to a ligand, which comprises: comparing signals obtained by the NMR measurement of a complex of a protein and a specific ligand, with signals obtained by the NMR measurement of only a protein; and determining by the method according to any one of claims 1 to 7, the assignment of a signal whose chemical shift has been changed.

10. A reagent kit used for the method of determining the assignment of signals obtained by the NMR measurement of a protein by the method according to any one of claims 1 to 7, which comprises: one or more types of amino acids, wherein at least the carbon atoms at positions 2 and 1 have been labeled with ¹³C and the nitrogen atom at position 2 has been labeled with ¹⁵N; and multiple amino acids wherein the nitrogen atom at position 2 has been labeled with ¹⁵N and the carbon atoms at positions 2 and 1 have not been labeled with ¹³C.

11. A reagent kit used for the method of determining the assignment of signals obtained by the NMR measurement of a protein by the method according to any one of claims 1 to 7, which comprises: one or more types of amino acids, wherein at least the carbon atoms at positions 2 and 1 have been labeled with ¹³C and the nitrogen atom at position 2 has been labeled with ¹⁵N; multiple amino acids wherein the nitrogen atom at position 2 has been labeled with ¹⁵N and the carbon atoms at positions 2 and 1 have not been labeled with ¹³C; a wheat germ extract for a cell-free protein synthesis; and an amino acid metabolic enzyme inhibitor.
